# EUROPEAN PATENT APPLICATION

(11) **EP 2 472 595 A1**
(43) Date of publication of application: **04.07.2012**
(21) Application number: 10811916.5
(22) Date of filing: 25.08.2010
(51) Int. Cl.: H01L 31/04

(54) **STACKED PHOTOVOLTAIC ELEMENT AND METHOD FOR MANUFACTURING STACKED PHOTOVOLTAIC ELEMENT**

(30) Priority: 26.08.2009 JP 2009195673; 26.08.2009 JP 2009195682
(71) Applicant: Sharp Kabushiki Kaisha, Osaka-shi, Osaka 545-8522 (JP)
(72) Inventor: HIGASHIKAWA, Makoto, Osaka-shi OSAKA 545-8522 (JP); SHIMIZU, Takako, Osaka-shi OSAKA 545-8522 (JP); HONDA, Shinya, Osaka-shi OSAKA 545-8522 (JP); ISHIKAWA, Yasuaki, Osaka-shi OSAKA 545-8522 (JP); SANO, Yuichi, Osaka-shi OSAKA 545-8522 (JP)
(74) Representative: Müller - Hoffmann & Partner
(86) International application number: PCT/JP2010/064407
(87) International publication number: WO 2011/024867

(57) **Abstract**

A stack-type photovoltaic element with improved conversion efficiency having an intermediate layer and a method of manufacturing the same are provided. A stack-type photovoltaic element (100) according to the present invention includes a first photovoltaic element portion (3) and a second photovoltaic element portion (5) from a substrate (1) side, as well as at least one intermediate layer (7) between the first photovoltaic element portion (3) and the second photovoltaic element portion (5). The intermediate layer (7) is formed from a metal oxide film having an oxygen atom concentration/metal atom concentration ratio not lower than 0.956 and not higher than 0.976.

## Description

### TECHNICAL FIELD

The present invention relates to a stack-type photovoltaic element and a method of manufacturing a stack-type photovoltaic element.

### BACKGROUND ART

A method for improving photoelectric conversion efficiency with a method of providing a transparent conductive film between photovoltaic elements and using the film as a selective reflection layer in a stack-type photovoltaic element in which a plurality of photovoltaic elements are stacked has been known.

For example, Japanese Patent Laying-Open No. 2004-311970 (PTL 1 ) discloses as such a method, a method of adopting a selective reflection layer having sheet resistance of a single film not lower than 100 kΩ/□ and not higher than 100 MΩ/□. With the use of the selective reflection layer, electrical defects of a photovoltaic element caused by dust or the like at the time of film formation can be decreased. Thus, lowering in electromotive force in the entire element caused by a short-circuiting current spreading to other portions through electrical defects can be lessened (see [0011] and Fig. 9 of PTL 1).

### CITATION LIST

### PATENT LITERATURE

PTL 1: Japanese Patent Laying-Open No. 2004-311970

### SUMMARY OF INVENTION

### TECHNICAL. PROBLEM

PTL 1, however, has pointed out such a problem that, though good characteristics are exhibited so long as sheet resistance of a single film of a selective reflection layer is up to around 100 MΩ/□, when sheet resistance is as high as around 200 MΩ/□, conversion efficiency lowers due to great electric power loss caused by series resistance of the selective reflection layer ([0074] of PTL 1).

In addition, it has been found that, in a case where metal oxide is used for a selective reflection layer having conductivity described in PTL 1 between a first photovoltaic element portion and a second photovoltaic element portion, in a process for manufacturing a photovoltaic element or in a state where the photovoltaic element is used after manufacturing, conductivity lowers and leakage occurs due to mutual diffusion to a hydrogen-containing silicon layer which forms the first photovoltaic element portion or the second photovoltaic element portion.

### SOLUTION TO PROBLEM

The present invention was made in view of the above-described problem and was made based on a finding that a stack-type photovoltaic element with improved photoelectric conversion efficiency can be manufactured by employing a conductive film made of metal oxide and having high resistance as an intermediate layer and subjecting this intermediate layer to surface treatment using plasma containing a hydrogen gas.

Namely, a first form of a stack-type photovoltaic element according to the present invention is a stack-type photovoltaic element in which a first photovoltaic element portion and a second photovoltaic element portion are successively stacked from a substrate side, the stack-type photovoltaic element includes at least one intermediate layer between the first photovoltaic element portion and the second photovoltaic element portion, and the intermediate layer is formed from a metal oxide film having an oxygen atom concentration/metal atom concentration ratio not lower than 0.956 and not higher than 0.976.

A second form of a stack-type photovoltaic element according to the present invention is a stack-type photovoltaic element in which a first photovoltaic element portion and a second photovoltaic element portion are successively stacked from a substrate side, the stack-type photovoltaic element includes at least one intermediate layer between the first photovoltaic element portion and the second photovoltaic element portion, and the intermediate layer is formed from a metal oxide film having hydrogen atom concentration not lower than 2.5 × 10²⁰ atoms/cm³ and not higher than 4.9 × 10²¹ atoms/cm³.

A third form of a stack-type photovoltaic element according to the present invention is a stack-type photovoltaic element in which a first photovoltaic element portion and a second photovoltaic element portion are successively stacked from a substrate side, the stack-type photovoltaic element includes at least one intermediate layer between the first photovoltaic element portion and the second photovoltaic element portion, and the intermediate layer is formed from a metal oxide film having an oxygen atom concentration/metal atom concentration ratio not lower than 0.956 and not higher than 0.976 and hydrogen atom concentration not lower than 2.5 × 10²⁰ atoms/cm³ and not higher than 4.9 × 10²¹ atoms/cm³.

In the stack-type photovoltaic element according to the present invention, preferably, the intermediate layer has a first intermediate layer arranged on the first photovoltaic element portion and a second intermediate layer arranged on the first intermediate layer, and the second intermediate layer is higher in oxygen atom concentration/metal atom concentration ratio than the first intermediate layer.

In addition, in the stack-type photovoltaic element according to the present invention, preferably, the second intermediate layer is lower in hydrogen atom concentration than the first intermediate layer.

A fourth form of a stack-type photovoltaic element according to the present invention is a stack-type photovoltaic element in which a first photovoltaic element portion and a second photovoltaic element portion are successively stacked from a substrate side, the stack-type photovoltaic element includes at least one intermediate layer between the first photovoltaic element portion and the second photovoltaic element portion, and the intermediate layer is formed from a metal oxide film having sheet resistance not lower than 100 kΩ/□ and not higher than 26 MΩ/□.

A fifth form of a stack-type photovoltaic element according to the present invention is a stack-type photovoltaic element in which a first photovoltaic element portion and a second photovoltaic element portion are successively stacked from a substrate side, the stack-type photovoltaic element includes at least one intermediate layer between the first photovoltaic element portion and the second photovoltaic element portion, and the intermediate layer is formed of metal oxide having conductivity of a single film not lower than 2 × 10⁻¹² S/cm and not higher than 1 × 10⁻⁸ S/cm.

In the stack-type photovoltaic element according to the present invention, preferably, a p layer included in the second photovoltaic element portion is formed under such a condition that a dilution factor of a source gas with a hydrogen gas is 200 or higher.

In addition, the stack-type photovoltaic element according to the present invention preferably has an integrated structure.

A first form of a method of manufacturing a stack-type photovoltaic element according to the present invention includes the steps of: stacking a first photovoltaic element portion including at least one photovoltaic element on a substrate; stacking on the first photovoltaic element portion, an intermediate layer composed of metal oxide and having conductivity of a single film not lower than 2 × 10⁻¹² S/cm and not higher than 1 × 10⁻⁸ S/cm; exposing the intermediate layer to plasma containing hydrogen; and stacking a second photovoltaic element portion including at least one photovoltaic element on the intermediate layer exposed to the plasma containing hydrogen.

In the first form of the method of manufacturing a stack-type photovoltaic element according to the present invention, preferably, the step of stacking an intermediate layer is the step of stacking an intermediate layer having conductivity of a single film not lower than 1 × 10⁻¹⁰ S/cm and not higher than 1 × 10⁻⁸ S/cm.

A second form of a method of manufacturing a stack-type photovoltaic element according to the present invention includes the steps of: stacking a first photovoltaic element portion including at least one photovoltaic element on a substrate; stacking on the first photovoltaic element portion, an intermediate layer composed of metal oxide and having sheet resistance of a single film higher than 100 MΩ/□; exposing the intermediate layer to plasma containing hydrogen; and stacking a second photovoltaic element portion including at least one photovoltaic element on the intermediate layer exposed to the plasma containing hydrogen, and sheet resistance of the single film of the intermediate layer exposed to the plasma containing hydrogen is not lower than 100 kΩ/□ and not higher than 26 MΩ/□.

In the second form of the method of manufacturing a stack-type photovoltaic element according to the present invention, preferably, the step of stacking an intermediate layer is the step of stacking an intermediate layer having sheet resistance of the single film higher than 1 GΩ/□, and the intermediate layer subjected to the step of exposing the intermediate layer to plasma containing hydrogen has sheet resistance of the single film not lower than 300 kΩ/□ and not higher than 20 MΩ/□.

A third form of a method of manufacturing a stack-type photovoltaic element according to the present invention includes the steps of: stacking a first photovoltaic element portion including at least one photovoltaic element on a substrate; stacking an intermediate layer composed of metal oxide on the first photovoltaic element portion; exposing the intermediate layer to plasma containing hydrogen; and stacking a second photovoltaic element portion including at least one photovoltaic element on the intermediate layer exposed to the plasma, and the step of stacking an intermediate layer is performed with sputtering using a target mainly composed of substantially undoped metal oxide under such a condition that a ratio of a flow rate of oxygen to argon O₂/Ar is not lower than 1% and not higher than 10%.

In the method of manufacturing a stack-type photovoltaic element according to the present invention, preferably, the second photovoltaic element portion includes a microcrystalline semiconductor layer (5a) formed on the intermediate layer, and the step of exposing the intermediate layer to plasma containing hydrogen also serves as the step of forming the semiconductor layer (5a).

In the method of manufacturing a stack-type photovoltaic element according to the present invention, preferably, the metal oxide forming the intermediate layer is zinc oxide.

In the method of manufacturing a stack-type photovoltaic element according to the present invention, preferably, the intermediate layer has a thickness not smaller than 20 nm and not greater than 200 nm.

In the method of manufacturing a stack-type photovoltaic element according to the present invention, preferably, a semiconductor layer formed on an uppermost surface of the first photovoltaic element portion on which the intermediate layer is to be stacked is formed from a microcrystalline layer.

In the method of manufacturing a stack-type photovoltaic element according to the present invention, preferably, the microcrystalline layer is a microcrystalline silicon layer having crystallinity not lower than 1.5 and not higher than 10.

In the method of manufacturing a stack-type photovoltaic element according to the present invention, preferably, the microcrystalline layer is a microcrystalline silicon layer of which hydrogen content is not lower than 3 atomic % and not higher than 20 atomic %. In the method of manufacturing a stack-type photovoltaic element according to the present invention, preferably, the microcrystalline layer is a microcrystalline silicon layer having conductivity not lower than 5 × 10⁻¹ S/cm.

In the method of manufacturing a stack-type photovoltaic element according to the present invention, preferably, the microcrystalline layer is a microcrystalline silicon layer having a thickness not smaller than 1 nm and not greater than 20 nm.

In the method of manufacturing a stack-type photovoltaic element according to the present invention, preferably, the first photovoltaic element portion and the second photovoltaic element portion are constituted of a photovoltaic element composed of a silicon-based semiconductor.

In the method of manufacturing a stack-type photovoltaic element according to the present invention, preferably, the intermediate layer is composed of substantially undoped metal oxide.

In the method of manufacturing a stack-type photovoltaic element according to the present invention, a stack-type photovoltaic element having an integrated structure is preferably manufactured.

In the method of manufacturing a stack-type photovoltaic element according to the present invention, preferably, a photovoltaic element located on a light incident side of the stack-type photovoltaic element among a plurality of photovoltaic elements included in the first photovoltaic element portion or the second photovoltaic element portion includes a pin structure, and an i-type layer constituting the pin structure is composed of any of amorphous silicon, amorphous silicon carbide, and amorphous silicon monoxide.

In the method of manufacturing a stack-type photovoltaic element according to the present invention, preferably, a photovoltaic element located opposite to a light incident side of the stack-type photovoltaic element among a plurality of photovoltaic elements included in the first photovoltaic element portion or the second photovoltaic element portion includes a pin structure, and an i-type layer constituting the pin structure is composed of silicon containing a crystalline substance.

### ADVANTAGEOUS EFFECTS OF INVENTION

According to the present invention, since the intermediate layer of the stack-type photovoltaic element has prescribed characteristics, during a process for manufacturing a photovoltaic element or after manufacturing thereof, lowering in conductivity or occurrence of leakage thereby can be suppressed. Consequently, a photovoltaic element high in photoelectric conversion efficiency and less in variation in conversion efficiency during operation is obtained.

### BRIEF DESCRIPTION OF DRAWINGS

Fig. 1 is a schematic cross-sectional view showing one example of a structure of a stack-type photovoltaic element in a present first embodiment.
Fig. 2 is a schematic cross-sectional view showing one example of a structure of a stack-type photovoltaic element including an intermediate layer having a two-layered structure.
Fig. 3A is a schematic cross-sectional view of a multi-chamber-type plasma CVD apparatus.
Fig. 3B is a schematic cross-sectional view showing a construction of a first film formation chamber in Fig. 3A.
Fig. 4 is a schematic diagram showing one example of a structure of a stack-type photovoltaic element in a present second embodiment.
Fig. 5 is a cross-sectional view schematically showing one example of a structure of a stack-type photovoltaic element having an integrated structure.
Fig. 6 is a graph showing variation in conversion efficiency with respect to oxygen atom concentration/metal atom concentration in the intermediate layer in Discussion 1.
Fig. 7 is a graph showing variation in conversion efficiency with respect to hydrogen concentration in the intermediate layer in Discussion 2.
Fig. 8 is a graph showing variation in conductivity with respect to an O₂/Ar flow rate ratio in Discussion 3.
Fig. 9 is a graph showing variation in sheet resistance with respect to an O₂/Ar flow rate ratio in Discussion 3.
Fig. 10 is a graph showing variation in conversion efficiency with respect to an O₂/Ar flow rate ratio in Discussion 3.
Fig. 11 is a graph showing variation in conversion efficiency with respect to conductivity before plasma treatment in Discussion 3.
Fig. 12 is a graph showing variation in conversion efficiency with respect to sheet resistance after plasma treatment in Discussion 3.
Fig. 13 is a graph showing variation in conductivity before plasma treatment with respect to an O₂/Ar flow rate ratio in Discussion 5.
Fig. 14 is a graph showing variation in conversion efficiency with respect to an O₂/Ar flow rate ratio in Discussion 5.
Fig. 15 is a graph showing relation between a thickness of the intermediate layer and a current in a photovoltaic element in Discussion 6.
Fig. 16 is a graph showing variation in series resistance with respect to a thickness of the intermediate layer in Discussion 6.
Fig. 17 is a graph showing a voltage-current characteristic of a stack-type photovoltaic element in Discussion 8.

### DESCRIPTION OF EMBODIMENTS

The present invention will be described hereinafter in further detail. It is noted that the description of embodiments below is given with reference to the drawings and the same reference characters in the drawings of the subject application represent the same or corresponding elements.

Though the embodiments of the present invention will be described hereinafter with reference to the drawings, the present invention is not limited to each embodiment below.

Though a stack-type photovoltaic element having a superstrate-type structure will be described hereinafter by way of example, the following description is also applicable to a substrate-type structure. In addition, in the present invention, a semiconductor film composed of an amorphous semiconductor may be referred to as an "amorphous layer", a semiconductor film composed of a microcrystalline semiconductor may be referred to as a "microcrystalline layer", and a film composed of an amorphous or microcrystalline semiconductor may be referred to as a "semiconductor layer". In the present invention, microcrystalline means such a state that a mixed phase of a crystalline component having a small crystal particle size (approximately from several ten to thousand Å) and an amorphous component is formed.

### <First Embodiment: Tandem Structure>

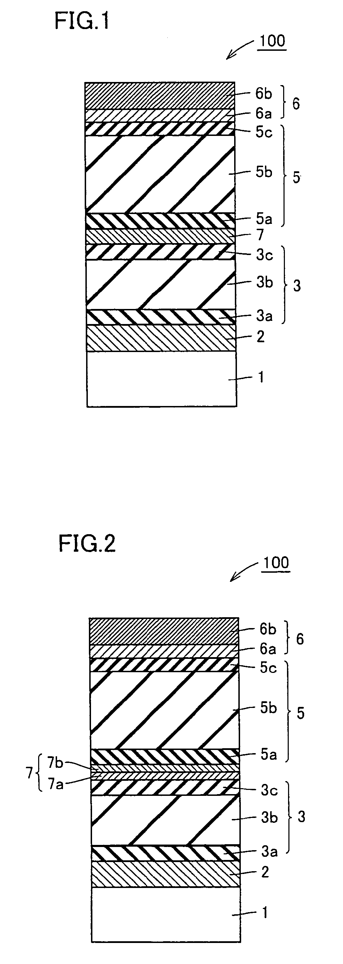

In the present first embodiment, a stack-type photovoltaic element including two photovoltaic element portions having a construction shown in Fig. 1 and a method of manufacturing the same will be described.

### (Stack-Type Photovoltaic Element)

Fig. 1 shows a schematic cross-sectional view showing one example of a structure of a stack-type photovoltaic element in the present first embodiment. As shown in Fig. 1, a stack-type photovoltaic element 100 in the present first embodiment has a stack-type structure including a first photovoltaic element portion 3 and a second photovoltaic element portion 5 provided on a substrate 1. In the present invention, an intermediate layer 7 composed of metal oxide is provided between first photovoltaic element portion 3 and second photovoltaic element portion 5. In stack-type photovoltaic element 100, light is incident on the substrate 1 side.

A first electrode 2 is provided on substrate 1. Substrate 1 and first electrode 2 are composed of a material having light transmission properties. Specifically, for example, preferably, substrate 1 is composed of glass or such a resin as polyimide, and it can be used as it has heat resistance to a plasma CVD formation process. First electrode 2 can be composed of SnO₂, indium tin oxide (ITO), or the like. A thickness of substrate 1 and first electrode 2 is not particularly limited and substrate 1 and first electrode 2 each have a desired shape.

First photovoltaic element portion 3 is provided on first electrode 2 and intermediate layer 7 is provided on an uppermost surface thereof. Then, second photovoltaic element portion 5 is provided on intermediate layer 7, and a second electrode 6 constituted of a transparent conductive film 6a and a metal film 6b is further provided on its upper surface. Transparent conductive film 6a is composed, for example, of ZnO, and a film composed, for example, of Ag can be used for metal film 6b.

### (Photovoltaic Element Portion)

Each of first photovoltaic element portion 3 and second photovoltaic element portion 5 includes at least one photovoltaic element.

As shown in Fig. 1, for example, first photovoltaic element portion 3 has a pin structure including a p layer 3a composed of amorphous silicon hydride (hereinafter also referred to as "amorphous Si hydride") or microcrystalline Si and an n layer 3c composed of amorphous Si hydride or microcrystalline Si on respective opposing surfaces of an i layer 3b composed of amorphous Si hydride and serving as a photoelectric conversion layer. A buffer layer such as an i-type amorphous layer composed, for example, of amorphous Si hydride can optionally be provided between p layer 3a and i layer 3b.

Similarly, for example, second photovoltaic element portion 5 has a pin structure including a p layer 5a composed of microcrystalline Si and an n layer 5c composed of microcrystalline Si on respective opposing surfaces of an i layer 5b composed of microcrystalline Si. A buffer layer composed, for example, of an i-type amorphous Si-based semiconductor can optionally be provided between i layer 5b and n layer 5c.

In first photovoltaic element portion 3 and second photovoltaic element portion 5, each p layer is a semiconductor film doped with such a p-type impurity atom as boron or aluminum. In addition, each n layer is a semiconductor film doped with such an n-type impurity atom as phosphorus. Moreover, a semiconductor film making up each i layer may be a completely non-doped semiconductor film or a semiconductor film of a p-type containing a trace amount of impurity or an n-type containing a trace amount of impurity and sufficiently having a photoelectric conversion function. Namely, in the present invention, the i-type layer should only substantially be intrinsic.

Here, i layer 3b of first photovoltaic element portion 3 of stack-type photovoltaic element 100 is greater in forbidden bandwidth than i layer 5b of second photovoltaic element portion 5. By thus setting the forbidden bandwidth of i layer 3b of first photovoltaic element portion 3 greater than the forbidden bandwidth of i layer 5b of second photovoltaic element portion 5, light incident on the substrate 1 side can be caused to contribute to photoelectric conversion over a wide wavelength band.

Each semiconductor film making up a photovoltaic element is not limited to those exemplified above, and it should only be a silicon-based semiconductor. As a silicon-based semiconductor, other than silicon (Si)-based compounds as described above, for example, a silicon carbide (SiC)-based compound, a silicon monoxide (SiO)-based compound, and the like can be employed. Alternatively, a semiconductor film composed of a silicon-based semiconductor may be an amorphous film (an amorphous layer) or a microcrystalline film. A silicon-based semiconductor making up an amorphous film or a microcrystalline film (a microcrystalline layer) includes a semiconductor in which the compound above is hydrogenated, fluorinated, or hydrogenated and fluorinated.

It is noted that first photovoltaic element portion 3 and second photovoltaic element portion 5 may be composed of a silicon-based (Si-based, SiC-based, or SiO-based) semiconductor of the same type in their entirety or silicon-based semiconductors different in type. In addition, each semiconductor layer of the p-type, the i-type, and the n-type may have a single-layered structure or a structure in which a plurality of layers are stacked. In the case of a structure in which a plurality of layers are stacked, respective layers may be composed of silicon-based semiconductors different in type.

### (Intermediate Layer)

Stack-type photovoltaic element 100 has intermediate layer 7 composed of metal oxide on first photovoltaic element portion 3 in Fig. 1, that is, on a surface opposite to a surface facing substrate 1, of the opposing surfaces of first photovoltaic element portion 3.

In the present embodiment, for intermediate layer 7 included in stack-type photovoltaic element 100, in order to improve efficiency of light absorption in first photovoltaic element portion 3 by optical reflection at an interface with first photovoltaic element portion 3, a material having great difference in index of refraction from a material used for first photovoltaic element portion 3 is suitable. In particular, intermediate layer 7 is characterized by having prescribed characteristics. A form in which intermediate layer 7 has the prescribed characteristics will be described below.

### First Form of Intermediate Layer

Intermediate layer 7 in the first form is formed from a metal oxide film having an oxygen atom concentration/metal atom concentration ratio not lower than 0.956 and not higher than 0.976. The ratio is more preferably not lower than 0.960 and further preferably not lower than 0.964. In addition, the ratio above is more preferably not higher than 0.975 and further preferably not higher than 0.974. When the oxygen atom concentration/metal atom concentration ratio of the metal oxide making up intermediate layer 7 satisfies the range above, conversion efficiency of stack-type photovoltaic element 100 improves.

### Second Form of Intermediate Layer

Intermediate layer 7 in the second form is formed from a metal oxide film having hydrogen atom concentration not lower than 2.5 × 10²⁰ atoms/cm³ and not higher than 4.9 × 10²¹ atoms/cm³. When intermediate layer 7 is formed from the metal oxide film having the prescribed hydrogen concentration above, conversion efficiency of stack-type photovoltaic element 100 improves.

### Third Form of Intermediate Layer

Intermediate layer 7 in the third form has sheet resistance of a single film not lower than 100 kΩ/□ and not higher than 26 MΩ/□. Intermediate layer 7 having this characteristic can readily be formed by stacking the intermediate layer on first photovoltaic element portion 3 and exposing the intermediate layer to plasma containing hydrogen.

In this case, when intermediate layer 7 has sheet resistance of a single film before exposure to plasma containing hydrogen higher than 100 MΩ/□, the sheet resistance of the single film after exposure to plasma containing hydrogen can be adjusted to the range above, which is preferred. Alternatively, when the sheet resistance of the single film before exposure to plasma containing hydrogen is higher than 1 GΩ/□, the sheet resistance of the single film after exposure to plasma containing hydrogen can be not lower than 300 kΩ/□ and not higher than 20 MΩ/□ and conductivity of the intermediate layer can be adjusted to a more appropriate range, which is preferred.

### Fourth Form of Intermediate Layer

Intermediate layer 7 in the fourth form has conductivity of a single film not lower than 2 × 10⁻¹² S/cm and not higher than 1 × 10⁻⁸ S/cm. When conductivity of the single film of intermediate layer 7 is not lower than 2 × 10⁻¹² S/cm and not higher than 1 × 10⁻⁸ S/cm, such stack-type photovoltaic element 100 that variation in conductivity by plasma treatment is accommodated in a tolerable range, conversion efficiency is high, and variation in conversion efficiency during use is less is obtained. In terms of further improved conversion efficiency, the conductivity is preferably not lower than 1 × 10⁻¹¹ S/cm and more preferably not lower than 1 × 10⁻¹⁰ S/cm. In addition, the conductivity of the single film of intermediate layer 7 is preferably not higher than 5 × 10⁻⁹ S/cm and more preferably not higher than 1 × 10⁻⁹ S/cm. When the conductivity of the single film is lower than 2 × 10⁻² S/cm, resistance of the intermediate layer is too high to increase series resistance and photoelectric conversion efficiency may not successfully be improved.

Here, the conductivity of the single film of the intermediate layer in the present invention refers to conductivity found with the following method.

Initially, a single film is formed by depositing metal oxide under the same conditions as in formation of the intermediate layer, on a glass substrate high in volume resistivity, such as alkali-free glass represented by #1373 (item number) manufactured by Coming Incorporated or silica glass,. Then, parallel electrodes are formed on a surface of the single film and a current when a voltage is applied across the parallel electrodes is measured. Then, conductivity of the intermediate layer is found based on the measured voltage-current characteristics. Measurement is conducted under such conditions as an atmospheric pressure and room temperature. Though conductivity only of the intermediate layer formed between the photovoltaic element portions in a stacked state cannot be measured, conductivity of the intermediate layer can be calculated with the measurement method above.

### Fifth Form of Intermediate Layer

As shown in Fig. 2, intermediate layer 7 in the fifth form has a two-layered structure constituted of a first intermediate layer 7a arranged on first photovoltaic element portion 3 and a second intermediate layer 7b arranged on first intermediate layer 7a, and second intermediate layer 7b is higher in oxygen atom concentration/metal atom concentration ratio than first intermediate layer 7a.

In order to reflect more light toward first photovoltaic element portion 3, it is possible to increase a thickness of intermediate layer 7. The present inventor, however, has revealed that, as intermediate layer 7 has a greater thickness, series resistance increases and voltage-current characteristics become poor. Then, the present inventors have continued dedicated studies and found that poor voltage-current characteristics can be overcome by forming intermediate layer 7 having the two-layered structure as above. In addition, the present inventors also have found increase in shunt resistance. Moreover, the present inventors have further found that, when second intermediate layer 7b is lower in hydrogen atom concentration than first intermediate layer 7a as well, an effect the same as above is achieved.

The present inventor has conceived that series resistance particularly tends to increase in particular when intermediate layer 7 has a thickness exceeding 200 nm. Based on this fact, in a case where intermediate layer 7 has a thickness greater than 200 nm in intermediate layers 7 in the first to fourth forms, intermediate layer 7 having the two-layered structure is more preferably employed. It is noted that, in the case of the two-layered structure, the thickness of intermediate layer 7 means a total thickness of thicknesses of first intermediate layer 7a and second intermediate layer 7b. In addition, second intermediate layer 7b is preferably lower in hydrogen atom concentration than first intermediate layer 7a.

Metal oxide making up intermediate layer 7 having the prescribed characteristics as above is preferably substantially undoped metal oxide. Here, substantially undoped metal oxide refers to such metal oxide that a dopant component as mixed in metal oxide serving as a source material is not higher than 0.01 % as expressed in atomic ratio. Since the atomic ratio is dependent on a type of metal oxide, it does not necessarily have to strictly be not higher than 0.01 %, however, the atomic ratio is a condition at which the i layer exhibits a photoelectric conversion function as what is called an intrinsic semiconductor.

Examples of metal oxide making up intermediate layer 7 having the prescribed characteristics as above include such metal oxides as indium oxide (In₂O₃), tin oxide (SnO₂), indium tin oxide (ITO), titanium oxide (TiO₂), and zinc oxide (ZnO), or a mixture of these metal oxides. In addition, a mixture of one type or a plurality of types of these metal oxides and magnesium oxide (MgO) etc., and the like are exemplified. Among these, use of zinc oxide (ZnO) as a main component is preferred because such characteristics as conductivity and sheet resistance as well as light transmission characteristics are readily adjusted in a desired range. The main component refers to a component occupying 50% or more in terms of an atomic ratio of a layer-forming component. In particular, zinc oxide preferably accounts for 90% or more.

Intermediate layer 7 preferably has a thickness not smaller than 20 nm and not greater than 200 nm. When intermediate layer 7 has a thickness not smaller than 20 nm, light reflection by intermediate layer 7 increases and hence a current increasing effect is exhibited. When intermediate layer 7 has a thickness not greater than 200 nm, increase in series resistance is not observed and good output is obtained. Intermediate layer 7 has a thickness more preferably not smaller than 50 nm and more preferably not greater than 150 nm. In the case of intermediate layer 7 having the two-layered structure, the upper limit of the thickness of intermediate layer 7 increases, and for example, a thickness not greater than 300 nm could sufficiently suppress increase in series resistance.

### (Method of Manufacturing Stack-Type Photovoltaic Element)

A method of manufacturing stack-type photovoltaic element 100 will be described hereinafter. Stack-type photovoltaic element 100 can be manufactured by forming successively from the light incident side, substrate 1, first electrode 2, first photovoltaic element portion 3, the intermediate layer, second photovoltaic element portion 5, and second electrode 6.

### (Step of Forming First Electrode)

Initially, first electrode 2 is formed on substrate 1. Substrate 1 is composed of glass, such a resin as polyimide, or the like having light transmission properties, and first electrode 2 formed from a transparent conductive film is formed on one surface with such a known method as CVD, sputtering, or vapor deposition. A transparent conductive film of SnO₂, ITO, ZnO, or the like is exemplified as first electrode 2.

### (Step of Stacking First Photovoltaic Element Portion)

Then, first photovoltaic element portion 3 is formed on the surface of first electrode 2, for example, with plasma CVD. By way of example of a formation method, a method of forming first photovoltaic element portion 3 with the use of a multi-chamber plasma CVD apparatus will be described below.

Initially, a construction of the multi-chamber plasma CVD apparatus will be described.

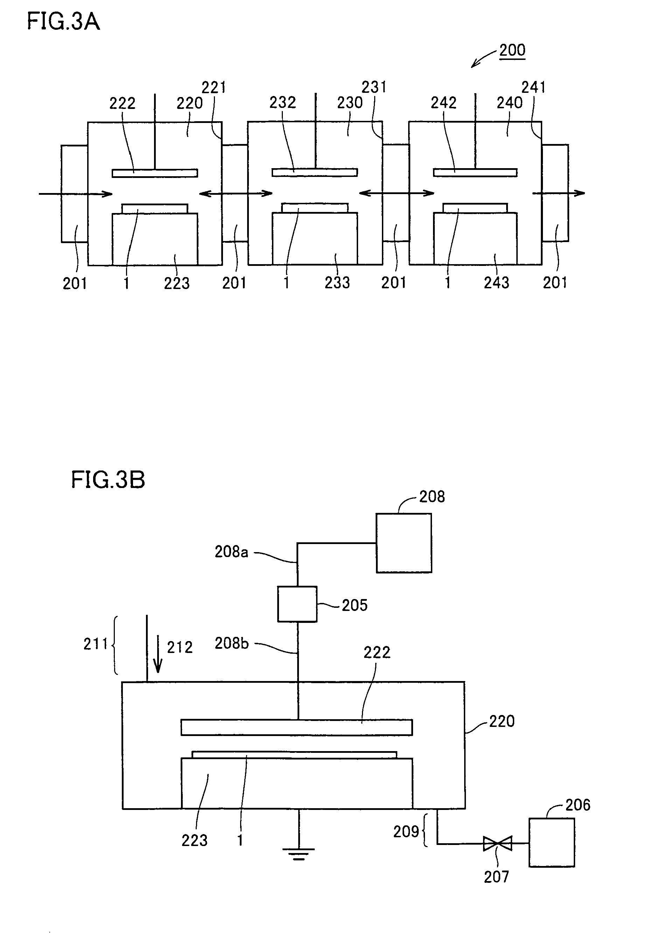

Fig. 3A is a schematic cross-sectional view of a multi-chamber-type plasma CVD apparatus. A multi-chamber-type plasma CVD apparatus 200 shown in Fig. 3A includes a first film formation chamber 220, a second film formation chamber 230, and a third film formation chamber 240. The construction is such that a gate valve 201 allowing communication between the film formation chambers or closing the film formation chamber is provided between the film formation chambers and substrate 1 can move between the film formation chambers through gate valve 201. A pair of electrodes is provided in each film formation chamber. Specifically, a cathode electrode 222 and an anode electrode 223 are provided in first film formation chamber 220, a cathode electrode 232 and an anode electrode 233 are provided in second film formation chamber 230, and a cathode electrode 242 and an anode electrode 243 are provided in third film formation chamber 240. It is noted that an arrow in the figure shows a direction in which substrate 1 can move.

Further detailed construction of each film formation chamber will be described by way of example of first film formation chamber 220. Fig. 3B is a schematic cross-sectional view showing the construction of the first film formation chamber in Fig. 3A. Second film formation chamber 230 and third film formation chamber 240 can be constructed similarly to first film formation chamber 220.

As shown in Fig. 3B, first film formation chamber 220 for forming a semiconductor layer therein, that can hermetically be sealed, includes a gas introduction portion 211 for introducing a replacement gas 212 into first film formation chamber 220 and a gas exhaust portion 206 for exhausting the replacement gas from first film formation chamber 220. An internal space of first film formation chamber 220 can have a size, for example, of approximately 1 m³.

In first film formation chamber 220, cathode electrode 222 and anode electrode 223 have a parallel plate type electrode structure. An inter-electrode distance between cathode electrode 222 and anode electrode 223 is determined by a desired treatment condition and it is generally set to approximately several mm to several ten mm. Outside first film formation chamber 220, a power supply portion 208 for supplying electric power to cathode electrode 222 and an impedance matching circuit 205 carrying out impedance matching between power supply portion 208 and cathode electrode 222 and anode electrode 223 are installed.

Power supply portion 208 is connected to one end of an electric power introduction line 208a. The other end of electric power introduction line 208a is connected to impedance matching circuit 205. An electric power introduction line 208b has one end connected to impedance matching circuit 205 and the other end connected to cathode electrode 222. A power supply portion capable of supplying a pulse-modulated (ON-OFF controlled) AC output or CW (continuous waveform) AC output as a result of switching is employed as power supply portion 208.

Anode electrode 223 is electrically grounded and substrate 1 is placed on anode electrode 223. Substrate 1 is arranged, for example, in such a state that first electrode 2 has been formed thereon. Though substrate 1 may be installed on cathode electrode 222, in order to lessen lowering in film quality due to damage by ions in plasma, it is generally placed on anode electrode 223.

Gas introduction portion 211 is provided in first film formation chamber 220. Gas 212 such as a dilution gas, a material gas, or a doping gas is introduced from gas introduction portion 211. A gas including a hydrogen gas is exemplified as the dilution gas, and a silane-based gas, a methane gas, a germane gas, and the like are exemplified as the material gas. A p-type impurity doping gas such as a diborane gas and an n-type impurity doping gas such as a phosphine gas are exemplified as the doping gas.

In first film formation chamber 220, gas exhaust portion 206 and a valve 207 for regulating a pressure are connected in series, and a gas pressure in first film formation chamber 220 is maintained substantially constant. Since slight error in gas pressure is caused if a gas pressure is measured in the vicinity of gas introduction portion 211 and a gas exhaust port 209 in the film formation chamber, a gas pressure is desirably measured at a position distant from gas introduction portion 211 and gas exhaust port 209. By supplying electric power to cathode electrode 222 in this state, plasma is generated between cathode electrode 222 and anode electrode 223. This plasma decomposes gas 212 introduced in first film formation chamber 220 so that a semiconductor layer can be formed on substrate 1.

A gas exhaust portion capable of evacuating first film formation chamber 220 to set a gas pressure therein to high vacuum at approximately 1.0 × 10⁻⁴ Pa can be employed as gas exhaust portion 206. In addition, from a point of view of simplification of the apparatus, lower cost, and improvement in throughput, a gas exhaust portion having such exhaust capability as setting a pressure in the film formation chamber to approximately 0.1 Pa may be employed.

Examples of simple gas exhaust portion 206 for low vacuum include a turbo molecular pump, a rotary pump, a mechanical booster pump, and a sorption pump, and such a pump is preferably used alone or in combination of two or more. A gas exhaust portion in which a turbo molecular pump and a rotary pump are connected in series can be used as typical gas exhaust portion 206.

A method of manufacturing a photovoltaic element with the use of plasma CVD apparatus 200 described above will now be described.

Initially, p layer 3a is formed in first film formation chamber 220. Specifically, first film formation chamber 220 is evacuated to 0.001 Pa and a temperature of substrate 1 provided with first electrode 2 and placed on anode electrode 223 is set to 200°C or lower. Then, a gas mixture is introduced in first film formation chamber 220 and valve 207 provided in an exhaust system maintains a pressure in first film formation chamber 220 substantially constant, for example, at a pressure not lower than 200 Pa and not higher than 3000 Pa.

For example, a gas mixture containing a silane gas, a hydrogen gas, and a diborane gas can be used as a gas mixture to be introduced in first film formation chamber 220. In order to further decrease an amount of absorption of light, a gas containing carbon atoms (for example, a methane gas) may be contained in the gas mixture above. In the gas mixture above, a flow rate of the hydrogen gas to the silane gas is desirably approximately several times (2 to 3 times) to several ten times (20 to 30 times) higher.

After the gas mixture above is introduced and a pressure in first film formation chamber 220 becomes stable, AC electric power from several kHz to 80 MHz is fed to cathode electrode 222 to thereby generate plasma between cathode electrode 222 and anode electrode 223. This plasma forms p layer 3a. Power density per unit area of cathode electrode 222 is set, for example, to 0.01 W/cm² or higher and 0.3 W/cm² or lower. Such power density should only be adjusted with a known method, in terms of film formation characteristics and a film formation rate.

After power density above is maintained and p layer 3a reaches a desired thickness, feed of electric power is stopped. Thereafter, first film formation chamber 220 is evacuated to produce vacuum therein. A thickness of p layer 3a can increase in proportion to the total amount of fed electric power (power density × time). In terms of providing sufficient internal electric field to i layer 3b, p layer 3a has a thickness preferably not smaller than 2 nm and more preferably not smaller than 5 nm. In terms of necessity of suppression of a light absorption amount on an incident side of a non-active layer, p layer 3a has a thickness preferably not greater than 50 nm and more preferably not greater than 30 nm.

In a case where first photovoltaic element portion 3 includes a buffer layer, a buffer layer can be formed in succession to p layer 3a in first film formation chamber 220. The buffer layer can be formed with a method similar to the method of forming p layer 3a, except for using as a gas mixture to be introduced in first film formation chamber 220, a gas mixture of a silane gas and a hydrogen gas, or a gas containing hydrocarbon such as a methane gas as further mixed in such a gas mixture.

In a case of providing a buffer layer, a thickness thereof is not particularly limited, however, in order to suppress diffusion of such a p-type impurity as boron atoms from p layer 3a to i layer 3b, the thickness is desirably not smaller than 2 nm. On the other hand, in order to suppress a light absorption amount to increase light reaching i layer 3b, the thickness is desirably as small as possible and a buffer layer normally has a thickness not greater than 50 nm.

By forming an i-type amorphous layer which is a buffer layer, concentration of impurity atoms such as boron in an atmosphere in first film formation chamber 220 is lowered and hence introduction of impurity atoms into i layer 3b formed next can be reduced.

Then, i layer 3b composed, for example, of amorphous Si hydride is formed. I layer 3b is formed, for example, in second film formation chamber 230. I layer 3b can be formed with a method similar to that for p layer 3a above, except for use of a different film formation chamber and use of a gas mixture containing, for example, a silane gas and a hydrogen gas as a gas mixture to be introduced in film formation chamber 230. In a case of forming i layer 3b, a flow rate of the hydrogen gas to the silane gas in the gas mixture above is preferably approximately several times to several ten times higher, for example, at least 5 times to at most 30 times higher, and i layer 3b of good quality can be formed by satisfying such relation of a flow rate.

I layer 3b preferably has a thickness not smaller than 0.05 µm and not greater than 0.25 µm, in consideration of a light absorption amount and lowering in photoelectric conversion characteristics due to deterioration by light.

N layer 3c is then formed. N layer 3c is formed, for example, in third film formation chamber 240. N layer 3c can be formed with a method similar to that for p layer 3a, except for use of a different film formation chamber and use of a gas mixture containing, for example, a silane gas, a hydrogen gas, and a phosphine gas as the gas mixture to be introduced in film formation chamber 240. In a case of forming n layer 3c, a flow rate of the hydrogen gas to the silane gas in the gas mixture above is preferably at least 5 times and at most 300 times higher and preferably in a range from at least 30 times and at most 300 times higher.

In order to provide sufficient internal electric field to i layer 3b, n layer 3c has a thickness preferably not smaller than 2 nm. On the other hand, in order to suppress an amount of light absorption in n layer 3c which is a non-active layer, the thickness is desirably as small as possible and the n layer normally has a thickness not greater than 50 nm.

Through the steps above, first photovoltaic element portion 3 including i layer 3b serving as a photoelectric conversion layer can be formed.

### (Step of Stacking Intermediate Layer)

In order to stack intermediate layer 7 having the prescribed characteristics described above, the present step can be performed, for example, as follows.

Initially, substrate 1 on which first photovoltaic element portion 3 has been formed is arranged in a known sputtering apparatus. Then, while a gas mixture of an argon gas and an oxygen gas is introduced in the apparatus, sputtering using a target mainly composed of substantially undoped metal oxide is carried out.

In sputtering above, a ratio of a flow rate of the oxygen gas to the argon gas O₂/Ar is preferably not lower than 1 % and not higher than 10%, more preferably not lower than 1% and not higher than 8%, and further preferably not lower than 2% and not higher than 5%. As the ratio of the flow rate between the argon gas and the oxygen gas is in the range above, conversion efficiency is further improved.

Regarding sputtering conditions, so long as the ratio of the flow rate above is satisfied, other temperature, pressure, power density, or the like should only be varied as appropriate depending of a film formation rate. For example, such conditions as a temperature not lower than 70°C and not higher than 150°C, a pressure not lower than 0.05 Pa and not higher than 0.75 Pa, and power density not lower than 1 W/cm² and not higher than 5 W/cm² are desirable. A thickness of intermediate layer 7 should only be adjusted by a time period during which electric power is applied.

By way of example, the ratio of the flow rate of the oxygen gas to the argon gas O₂/Ar supplied into a reaction chamber under such conditions as a pressure of 0.21 Pa, a substrate temperature set to 120°C, and applied electric power of 11.7 kW is preferably changed in a range not lower than 1% and not higher than 7.5%. Thus, intermediate layer 7 satisfying the range of the oxygen atom concentration/metal atom concentration ratio, the range of hydrogen atom concentration, and the like described above can readily be manufactured and conversion efficiency of the obtained stack-type photovoltaic element can be improved.

In a case of forming intermediate layer 7 having first intermediate layer 7a and second intermediate layer 7b as shown in Fig. 2, preferably, first intermediate layer 7a is formed with the ratio of the flow rate of the oxygen gas to the argon gas O₂/Ar being set to a prescribed ratio, and thereafter second intermediate layer 7b is formed with the ratio of the flow rate higher than the prescribed ratio being set. In this case, second intermediate layer 7b can readily be higher in oxygen atom concentration/metal atom concentration ratio than first intermediate layer 7a.

Further, in the present step, sputtering may be carried out using a target having purity not lower than 4 N. In this case, conductivity of intermediate layer 7 can readily be adjusted to 1 × 10⁻⁸ S/cm or lower. Namely, with the target having purity lower than 4 N, conductivity may not lower to 10⁻⁵ S/cm or lower or to 10⁻⁸ S/cm or lower, due to introduction of an impurity. If the ratio of the flow rate between the argon gas and the oxygen gas is set in the range above, conductivity and sheet resistance of intermediate layer 7 are readily set in the range according to the present invention.

For example, single metal oxide such as zinc oxide can be used for the target. Alternatively, such a target that a metal compound such as zinc oxide occupies 80% or more of target forming atoms with the remainder magnesium, calcium and the like may be employed.

### (Step of Exposure to Plasma Containing Hydrogen)

The present embodiment can include the step of exposing intermediate layer 7 to plasma containing hydrogen. The present step is the step of treating intermediate layer 7 so as to adjust its characteristics under such a condition that no layer is formed by plasma containing hydrogen. In addition, the present step can also serve as the step of forming a conductive semiconductor layer (p layer 5a of second photovoltaic element portion 5).

For example, in a case where the present step is performed under a condition where no layer is formed, the present step can be performed by using a gas mixture of a hydrogen gas and an impurity doping gas obtained by excluding a silane gas from a film formation gas for forming p layer 5a to be formed on intermediate layer 7.

Alternatively, the present step can also be performed by using only the hydrogen gas.

A condition in a case where the step also serves as the step of forming p layer 5a can be set to a condition for forming microcrystalline p layer 5a, so long as intermediate layer 7 before plasma treatment satisfies the prescribed characteristics described above.

In a specific method, for example, substrate 1 above which intermediate layer 7 has been formed is arranged in a film formation chamber of the plasma CVD apparatus, a pressure in the film formation chamber is regulated to 240 Pa or higher and 3600 Pa or lower, and a gas serving as a plasma source containing hydrogen is introduced. As a gas serving as the plasma source containing hydrogen, a gas mixture containing a hydrogen gas and a material gas such as SiH₄, CH₄, or CO_{2,} or a gas mixture containing the hydrogen gas and a gas of a dopant component such as B₂H₆ or PH₃ can be employed. In addition, a gas mixture containing the hydrogen gas, the material gas, and the gas of the dopant component may be employed. By applying electric power from 0.01 W/cm² to 0.5 W/cm² to the gas mixture, plasma can be generated.

Increase in time period during which intermediate layer 7 is exposed to plasma containing hydrogen tends to lead to increase in hydrogen concentration and sheet resistance in intermediate layer 7, and increase in pressure in the film formation chamber tends to shorten a time period for achieving certain sheet resistance. Such conditions can be changed, depending on a size of substrate 1 or a thickness of intermediate layer 7. Specifically, treatment efficiency can be improved by increasing a reaction time period or a pressure in the film formation chamber as the substrate is greater or the thickness of the intermediate layer is greater.

If the pressure in the film formation chamber is lower than the range above, the surface of intermediate layer 7 is further reduced and a portion (a region) high in conductivity tends to partially be formed in the surface, which results in lowering in transmittance. In addition, characteristics may lower due to increase in series resistance caused by defective contact between intermediate layer 7 and other photovoltaic element portions. This phenomenon seems to occur by the influence of conductivity distribution in a direction of thickness of intermediate layer 7.

In the present invention, intermediate layer 7 has sheet resistance of a single film before exposure to plasma containing hydrogen preferably higher than 100 MΩ/□ and sheet resistance after exposure to plasma containing hydrogen preferably not lower than 100 kΩ/□ and not higher than 26 MΩ/□. In addition, intermediate layer 7 has sheet resistance of a single film before exposure to plasma containing hydrogen more preferably higher than 1 GΩ/□ and sheet resistance after exposure to plasma containing hydrogen more preferably not lower than 300 kΩ/□ and not higher than 20 MΩ/□.

When sheet resistance of the single film of intermediate layer 7 before exposure to plasma containing hydrogen is higher than 100 MΩ/□, sheet resistance of intermediate layer 7 after exposure to plasma containing hydrogen can readily be adjusted to 100 kΩ/□ or higher and 26 MΩ/□ or lower, which is preferred. Alternatively, when sheet resistance of the single film of intermediate layer 7 before exposure to plasma containing hydrogen is higher than 1 GΩ/□, sheet resistance of the single film of intermediate layer 7 after exposure to plasma containing hydrogen can readily be adjusted to the range not lower than 300 kΩ/□ and not higher than 20 MΩ/□, which is preferred. When the metal oxide film making up intermediate layer 7 satisfies such sheet resistance or conductivity described above, conversion efficiency of the element can be improved, which is preferred. Sheet resistance can be measured by using Hiresta UP MCP-HT450 manufactured by Mitsubishi Chemical Corporation.

### (Step of Stacking Second Photovoltaic Element Portion)

The step of stacking second photovoltaic element portion 5 including at least one photovoltaic element can be performed with a method similar to that for first photovoltaic element portion 3.

For example, second photovoltaic element portion 5 can be a photovoltaic element including a pin structure constituted of p layer 5a, i layer 5b, and n layer 5c each of which is formed from a microcrystalline layer. In addition, second photovoltaic element portion 5 includes a form in which a buffer layer is provided between p layer 5a and i layer 5b, a form in which i layer 5b is amorphous, and the like. I layer 5b in second photovoltaic element portion 5 is preferably formed under the following conditions, in order to be narrower in forbidden bandwidth than i layer 3b in the first photovoltaic element portion.

Initially, p layer 5a is formed on intermediate layer 7. A microcrystalline layer is preferably formed as p layer 5a. By forming a microcrystalline semiconductor film after deposition of intermediate layer 7, hydrogen permeates moderately through intermediate layer 7. It is considered that an electric conduction phenomenon occurs in intermediate layer 7 composed of metal oxide owing to this hydrogen and that connection between the photovoltaic elements can more efficiently be made.

Microcrystalline p layer 5a formed on intermediate layer 7 above can be formed, for example, under the following formation conditions. Substrate 1 provided with first photovoltaic element portion 3 and intermediate layer 7 is arranged in the film formation chamber, a temperature of substrate 1 is set to 200°C or lower, a pressure in the film formation chamber during formation is set to 240 Pa or higher and 3600 Pa or lower, and power density per unit area of the cathode electrode is set to 0.01 W/cm² or higher and 0.5 W/cm² or lower.

In a case where p layer 5a of second photovoltaic element portion 5 stacked on intermediate layer 7 is a microcrystalline layer, photoelectric conversion efficiency tends to be further improved. In particular, deposition is desirably carried out under such conditions as power density not lower than 50 mW/cm² and not higher than 150 mW/cm² and a hydrogen dilution factor of the silane gas forming the p layer not smaller than 100 and not greater than 300. The hydrogen dilution factor of the silane gas is more desirably not smaller than 200 and not greater than 300.

In a case of formation under such conditions, intermediate layer 7 is exposed to plasma containing hydrogen and hydrogen diffuses into p layer 5a, and thus a film having moderate resistance is obtained. Intermediate layer 7 having moderate resistance in an in-plane direction and having low series resistance at a junction interface with the photovoltaic element can thus be formed. It is noted that the hydrogen dilution factor refers to a value indicated by a ratio of a flow rate of a hydrogen gas to a source material gas (such as H₂ gas flow rate/SiH₄ gas flow rate).

For example, a gas containing a silane gas, a hydrogen gas, and a diborane gas can be used as a gas mixture to be introduced into the film formation chamber. A flow rate of the hydrogen gas to the silane gas is desirably approximately several ten times to several hundred times higher and further desirably approximately 30 times to 300 times higher.

P layer 5a has a thickness preferably not smaller than 2 nm, in order to provide sufficient internal electric field to i layer 5b. On the other hand, in order to suppress an amount of light absorption in p layer 5a which is a non-active layer to increase light reaching i layer 5b, p layer 5a desirably has a thickness as small as possible and it normally has a thickness not greater than 50 nm.

I layer 5b is then formed. I layer 5b can be formed, for example, under the following formation conditions. A substrate temperature is set to 200°C or lower, a pressure in the film formation chamber during formation is set to 240 Pa or higher and 3600 Pa or lower, and power density per unit area of the cathode electrode is set to 0.02 W/cm² or higher and 0.5 W/cm² or lower.

For example, a gas containing a silane gas and a hydrogen gas can be used as a gas mixture to be introduced into the film formation chamber. A flow rate of the hydrogen gas to the silane gas is desirably approximately 30 times to several hundred times higher and further desirably approximately 30 times to 300 times higher.

I layer 5b has a thickness preferably not smaller than 0.5 µm and more preferably not smaller than 1 µm, in order to ensure a sufficient light absorption amount. On the other hand, in terms of securing good productivity, i layer 5b has a thickness preferably not greater than 20 µm and more preferably not greater than 15 µm. Thus, i layer 5b having good crystallinity (for example, crystallinity from 5 to 10) can be formed.

N layer 5c is then formed. N layer 5c can be formed, for example, under the following formation conditions. A substrate temperature is set to 200°C or lower, a pressure in the film formation chamber during formation is set to 240 Pa or higher and 3600 Pa or lower, and power density per unit area of the cathode electrode is set to 0.02 W/cm² or higher and 0.5 W/cm² or lower.

For example, a gas containing a silane gas, a hydrogen gas, and a phosphine gas can be used as a gas mixture to be introduced into the film formation chamber. A flow rate of the hydrogen gas to the silane gas is desirably approximately several ten times to several hundred times higher and further desirably approximately 30 times to 300 times higher.

N layer 5c has a thickness preferably not smaller than 2 nm, in order to provide sufficient internal electric field to i layer 5b. On the other hand, in order to suppress an amount of light absorption in n layer 5c which is a non-active layer, n layer 5c desirably has a thickness as small as possible and it normally has a thickness not greater than 50 nm, although the thickness is not limited to this range.

### (Step of Forming Second Electrode)

Second electrode 6 is then formed on second photovoltaic element portion 5. Second electrode 6 is constituted of transparent conductive film 6a and metal film 6b and they are successively formed. A film made of SnO₂, ITO, ZnO, or the like can be used as transparent conductive film 6a. A film made of such a metal as silver and aluminum can be used as metal film 6b. Transparent conductive film 6a and metal film 6b are formed with such a method as CVD, sputtering, or vapor deposition. Transparent conductive film 6a does not have to be provided.

As described above, stack-type photovoltaic element 100 in the present first embodiment is manufactured.

According to the first embodiment described in detail above, the intermediate layer having the prescribed characteristics is provided between the first photovoltaic element portion and the second photovoltaic element portion. In this case, occurrence of leakage or lowering in conductivity due to mutual diffusion between a silicon layer containing hydrogen and metal oxide making up the intermediate layer in a process for manufacturing a photovoltaic element or in a state where the photovoltaic element is used after manufacturing, as observed when metal oxide having conductivity described, for example, in PTL 1 is employed, can be suppressed or prevented. Therefore, according to the present embodiment, photoelectric conversion efficiency can be improved.

Though a case where a semiconductor layer is formed with a multi-chamber-type plasma CVD apparatus having three film formation chambers as shown in Fig. 3A has been exemplified in the description above, the case is not limited to the form above and such a form that an apparatus provided with four or more film formation chambers is used to form a p layer and a buffer layer in different film formation chambers may be applicable. In addition, a single-chamber plasma CVD apparatus may similarly be employed. In this case, since semiconductor layers of the p-type, the i-type and the n-type are formed in a single film formation chamber, a known gas replacement step is preferably provided between the steps. Alternatively, the step of forming a semiconductor layer with a method other than plasma CVD may be included.

### <Second Embodiment: Triple-Cell Structure>

The present second embodiment relates to a stack-type photovoltaic element in which a first photovoltaic element portion includes two photovoltaic elements.

### (Stack-Type Photovoltaic Element)

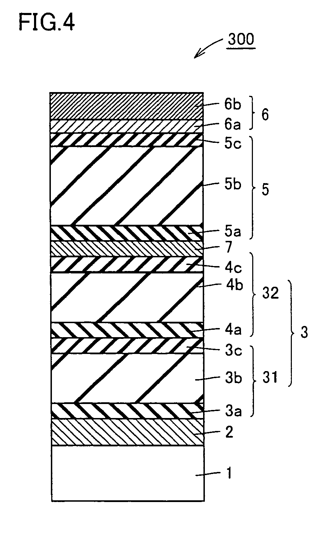

A structure other than the first photovoltaic element portion including two photovoltaic elements is the same as in the first embodiment above. Namely, as shown in Fig. 4, a stack-type photovoltaic element having a triple-cell structure has first photovoltaic element portion 3 obtained by stacking two pin structures and second photovoltaic element portion 5 having a single pin structure, and includes intermediate layer 7 between first photovoltaic element portion 3 and second photovoltaic element portion 5.

### (Method of Manufacturing Stack-Type Photovoltaic Element)

A method of manufacturing a stack-type photovoltaic element 300 having a triple-cell structure will be described hereinafter with reference to Fig. 4. Stack-type photovoltaic element 300 can be manufactured by forming successively from the light incident side, substrate 1, first electrode 2, first photovoltaic element portion 3, intermediate layer 7, second photovoltaic element portion 5, and second electrode 6.

### (Step of Forming First Electrode)

Initially, first electrode 2 is formed on substrate 1. A glass substrate, a resin substrate made of polyimide or the like, and the like having heat resistance in a process for manufacturing an element and light transmission properties are exemplified as substrate 1. A transparent conductive film of SnO₂ ITO, ZnO, or the like is exemplified as first electrode 2. A transparent conductive film making up first electrode 2 can be formed with such a known method as CVD, sputtering, or vapor deposition.

### (Step of Stacking First Photovoltaic Element Portion)

Then, first photovoltaic element portion 3 is formed on first electrode 2 formed on substrate 1. First photovoltaic element portion 3 has a first pin structure 31 constituted of p layer 3a, i layer 3b, and n layer 3c and a second pin structure 32 constituted of a p layer 4a, an i layer 4b, and an n layer 4c.

First pin structure 31 constituted of player 3a, i layer 3b, and n layer 3c can be formed with a method similar to the method of manufacturing first photovoltaic element portion 3 in the first embodiment above.

After pin structure 31 is formed on first electrode 2, second pin structure 32 in first photovoltaic element portion 3 is stacked. For example, i layer 4b in first photovoltaic element portion 3 is composed of amorphous Si hydride and the p layer and the n layer other than that can be formed with a formation method similar to that for first pin structure 31 above. A thickness of a semiconductor layer other than i layer 4b and a condition for formation thereof may be identical to or different from those for first pin structure 31 1 above.

For example, initially, p layer 4a composed of amorphous SiC is formed with a method similar to that for p layer 3a in first pin structure 31.

Then, for example, i layer 4b composed of amorphous Si hydride is formed. A thickness of i layer 4b is preferably set to a value from 50 nm to 500 nm, in consideration of a light absorption amount and lowering in photoelectric conversion characteristics due to deterioration by light. In addition, i layer 4b in second pin structure 32 is desirably narrower in forbidden bandwidth than i layer 3b in first pin structure 31. By setting such a forbidden bandwidth, light in a wavelength band that has not successfully been absorbed in the photoelectric conversion layer on the substrate side can be absorbed in the photoelectric conversion layer in second pin structure 32 and thus incident light can effectively be made use of.

In order for i layer 4b to be narrower in forbidden bandwidth than i layer 3b in first pin structure 31 above, manufacturing under conditions below is exemplified.

Initially, a background pressure in the film formation chamber is set to approximately 0.001 Pa by evacuation to produce vacuum and a temperature of substrate 1 is set to 150°C or higher and 250°C or lower. Then, a gas mixture is introduced into the film formation chamber and a pressure in the film formation chamber is maintained substantially constant by using a pressure-regulating valve.

The pressure in the film formation chamber is set, for example, to 10 Pa or higher and 3000 Pa or lower. For example, a gas containing a silane gas and a hydrogen gas can be used as the gas mixture to be introduced in the film formation chamber. A flow rate of the hydrogen gas to the silane gas (H₂/SiH₄) is desirably one time or higher and more preferably at least 5 times and at most 30 times higher.

After the pressure in the film formation chamber becomes stable, AC electric power having a frequency, for example, of 13.56 MHz is fed to the cathode electrode to generate plasma between the cathode electrode and the anode electrode, to thereby form i layer 4b. Power density per unit area of the cathode electrode can be set, for example, to 0.01 W/cm² or higher and 0.3 W/cm² or lower. A frequency from several kHz to a VHF band and further a frequency in a microwave band may be used as the frequency above.

After i layer 4b having a desired thickness is formed as above, feed of AC electric power is stopped and thereafter vacuum is produced in the film formation chamber by evacuation.

Then, with a method similar to that for n layer 3c in first pin structure 31, n layer 4c is formed. Thus, first photovoltaic element portion 3 in which second pin structure 32 is stacked on first pin structure 31 is formed.

It is noted that the forbidden bandwidth of i layer 3b in first pin structure 31 above may be equal to or narrower than that of i layer 4b in second pin structure 32. In this case as well, i layer 4b in second pin structure 32 contributes to absorption of light that could not fully be absorbed by i layer 3b in first pin structure 31.

In addition, generally, as the i layer has a greater thickness, deterioration by light of the i layer further affects photoelectric conversion efficiency. Even though light deterioration characteristics per unit thickness of the i layer are the same, photoelectric conversion efficiency more significantly lowers. In contrast, according to the present second embodiment, by forming two photovoltaic elements each having the i layer, each i layer included in the first photovoltaic element portion can relatively be thin and hence deterioration of the i layer included in the first photovoltaic element portion can be suppressed.

A buffer layer may be provided between the p layer and the i layer in each of first pin structure 31 and second pin structure 31, and such a buffer layer can similarly be formed as in the first embodiment above.

### (Step of Stacking Intermediate Layer)

The step of stacking intermediate layer 7 formed from a metal oxide film having prescribed characteristics is performed with a method similar to that in the first embodiment.

### (Step of Exposure to Plasma Containing Hydrogen)

Intermediate layer 7 can be exposed to plasma containing hydrogen, with a method similar to that in the first embodiment.

### (Step of Stacking Second Photovoltaic Element Portion)

Then, second photovoltaic element portion 5 is formed. Second photovoltaic element portion 5 can be formed with a method similar to that in the first embodiment above.

### (Step of Forming Second Electrode)

Second electrode 6 can be formed with a method similar to that in the first embodiment above.

Stack-type photovoltaic element 300 having the triple-cell structure can be formed as above. Since stack-type photovoltaic element 300 thus manufactured includes intermediate layer 7 having the prescribed characteristics, it can have high conversion efficiency.

### <Third Embodiment: Integrated Structure>

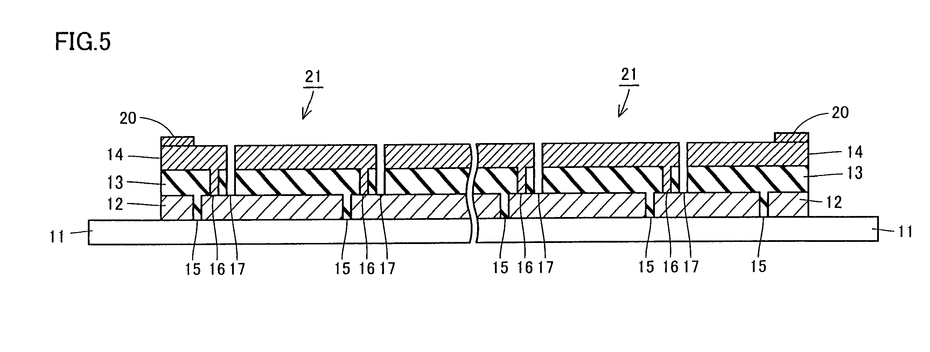

Intermediate layer 7 described in the first and second embodiments above further exhibits the effects above when there are many leakage points, and hence it is suitable for a case where a stack-type photovoltaic conversion element has an integrated structure. The integrated structure refers to a structure including a cell-integrated portion and various forms disclosed in Japanese Patent Laying-Open No. 2008-109041 are exemplified. A stack-type photovoltaic element having an integrated structure shown in Fig. 5 will be described by way of example of the stack-type photovoltaic element having the integrated structure.

As shown in Fig. 5, a first electrode layer 12 is isolated by a first isolation groove 15 embedded with a photovoltaic element portion 13, and photovoltaic element portion 13 and a second electrode layer 14 on a back surface are isolated by a second isolation groove 17. In addition, cells adjacent with a contact line 16 being interposed, the contact line being a portion from which photovoltaic element portion 13 has been removed by laser scribing, are connected electrically in series to thereby make up a cell-integrated portion 21. It is noted that a substrate 11, first electrode layer 12, photovoltaic element portion 13, and second electrode layer 14 correspond to substrate 1, first electrode 2, first photovoltaic element portion 3 and intermediate layer 7 and second photovoltaic element portion 5, and second electrode 6 in Fig. 1, respectively.

In addition, as shown in Fig. 5, an electrode 20 for current extraction is formed on a surface of second electrode layer 14 on each of opposing ends. This electrode 20 can be in a form in parallel to a longitudinal direction of second isolation groove 17.

In a case of having the integrated structure as in Fig. 5, increase in photoelectric conversion efficiency is significant.

### Examples

The present invention will be described hereinafter in further detail with reference to examples, however, the present invention is not limited thereto.

### <Discussion 1>

(Examples 1 to 7 and Comparative Example 1): Triple-Cell Structure, Oxygen Atom Concentration/Metal Atom Concentration Ratio

In Examples 1 to 5 and Comparative Example 1, the stack-type photovoltaic element having the triple-cell structure shown in Fig. 4 was fabricated.

Specifically, a photovoltaic element having the i layer composed of intrinsic amorphous Si hydride, the p layer composed of amorphous Si hydride, and the n layer composed of amorphous Si hydride was fabricated as the first pin structure in the first photovoltaic element portion. In addition, a photovoltaic element having the i layer composed of intrinsic amorphous Si hydride, the p layer composed of amorphous Si hydride, and the n layer composed of amorphous Si hydride was fabricated as the second pin structure. Moreover, a photovoltaic element having the i layer composed of intrinsic microcrystalline Si, the p layer composed of microcrystalline Si, and the n layer composed of microcrystalline Si was fabricated as the second photovoltaic element portion. The manufacturing method will specifically be described below.

### (Step of Forming First Electrode)

A glass substrate of 115 mm × 115 mm, which was #1373 (item number) manufactured by Coming Incorporated, was employed as the substrate. A 700-nm transparent conductive film composed of SnO₂ was formed as the first electrode on this glass substrate with thermal CVD.

### (Step of Stacking First Photovoltaic Element Portion)

The first photovoltaic element portion constituted of the first pin structure and the second pin structure was manufactured on the substrate on which the first electrode had been formed.

With regard to the first pin structure, the first photovoltaic element portion was formed by using the multi-chamber-type plasma CVD apparatus. Initially, the first film formation chamber was evacuated to 0.001 Pa and a temperature of the substrate provided with the first electrode was set to 200°C or lower. A gas mixture was introduced into the first film formation chamber and the pressure in the first film formation chamber was kept around 400 Pa by using a valve provided in an exhaust system. A gas mixture containing the silane gas, the hydrogen gas, and the diborane gas was employed as the gas mixture to be introduced into the first film formation chamber. In the gas mixture above, a flow rate of the hydrogen gas to the silane gas was set to 10 times higher.

After the gas mixture above was introduced and the pressure in the first film formation chamber became stable, AC electric power of 13.56 MHz was fed to the cathode electrode to generate plasma between the cathode electrode and the anode electrode. This plasma formed the p layer on the first electrode. Power density per unit area of the cathode electrode was set to 0.05 W/cm².

This state was left with power density above being maintained and feed of electric power was stopped when the p layer reached a thickness of 25 nm. Thereafter, the first film formation chamber was evacuated to produce vacuum therein.

Then, the i layer composed of amorphous Si hydride was formed. The i layer was formed with a method similar to that for the p layer above, except for use of the second film formation chamber and use of a gas mixture of the silane gas and the hydrogen gas as the gas mixture to be introduced in the film formation chamber. A flow rate of the hydrogen gas to the silane gas here was set to 10 times higher. When the thickness of the i layer reached 250 nm, supply of electric power was stopped and the second film formation chamber was evacuated.

Then, the n layer was formed in the third film formation chamber. The n layer was formed with a method similar to that for the p layer above, except for use of the third film formation chamber and use of a gas mixture containing the silane gas, the hydrogen gas, and the phosphine gas as the gas mixture to be introduced in the film formation chamber. A flow rate of the hydrogen gas to the silane gas in the gas -mixture here was set to 10 times higher. When the thickness of the n layer reached 25 nm, supply of electric power was stopped and thereafter the film formation chamber was evacuated.

Through the steps above, the first pin structure including the i layer serving as the photoelectric conversion layer and composed of amorphous Si hydride was formed.

Then, the second pin structure was stacked on the first pin structure. Regarding the second pin structure, the p layer and the n layer were composed of microcrystalline silicon and formed similarly to the first pin structure above. The i layer in the second pin structure was formed under conditions similar to those for the first pin structure. The thickness of the i layer was set to 0.5 µm. The first photovoltaic element portion was manufactured as above.

### (Step of Stacking Intermediate Layer)

The glass substrate above on which components up to the first photovoltaic element portion had been fabricated was installed on a substrate holder of a DC magnetron sputtering apparatus and a reaction chamber of the DC magnetron sputtering apparatus was evacuated until the pressure therein was set to 10⁻⁴ Pa or lower. After heating was carried out such that a substrate temperature attained to 150°C while carrying the substrate, an argon gas at 400 sccm was supplied from the gas introduction portion such that a ratio of a flow rate of the oxygen gas to the argon gas was adjusted to the ratio of the gas flow rate shown in Table 1. The ratio of the flow rate of the oxygen gas to the argon gas in each of Examples and Comparative Example was as shown in Table 1.

DC electric power of 11.7 kW was applied from a DC sputtering power supply to a target of 127 cm × 457 cm composed of non-doped zinc oxide (ZnO) not containing a dopant component and having purity of 4 N. Sputtering was carried out while a speed of carrying the substrate was adjusted such that a thickness of a film formed under each condition was equal and the intermediate layer composed of zinc oxide (ZnO) having a thickness of approximately 75 nm was formed. Composition of the metal oxide for the intermediate layer was adjusted by composition of the target.

### (Step of Stacking Second Photovoltaic Element Portion, Also Serving as Step of Exposure to Plasma Containing Hydrogen)

Then, a pin-type photovoltaic element composed of crystalline Si hydride was fabricated on the intermediate layer as the second photovoltaic element portion. The p layer of the second photovoltaic element portion was a microcrystalline layer and a flow rate of the hydrogen gas to the silane gas in the gas mixture was set to 259 times higher.

### (Step of Forming Second Electrode)

A 0.2-µm second electrode composed of Ag was formed on the second photovoltaic element portion to thereby manufacture the stack-type photovoltaic element. Such a stack-type photovoltaic element had the integrated structure, which was a three-tiered integrated cell in which a single cell was of 1-cm square. Specifically, as shown in Fig. 5, it is an integration of first isolation groove 15/contact line 16/second isolation groove 17 structures.

A three-tiered integrated module having a cell width of 20 mm and an integration pitch of 11 mm was cut from the fabricated stack-type photovoltaic element and characteristics of the element were evaluated.

### (Evaluation of Conversion Efficiency)

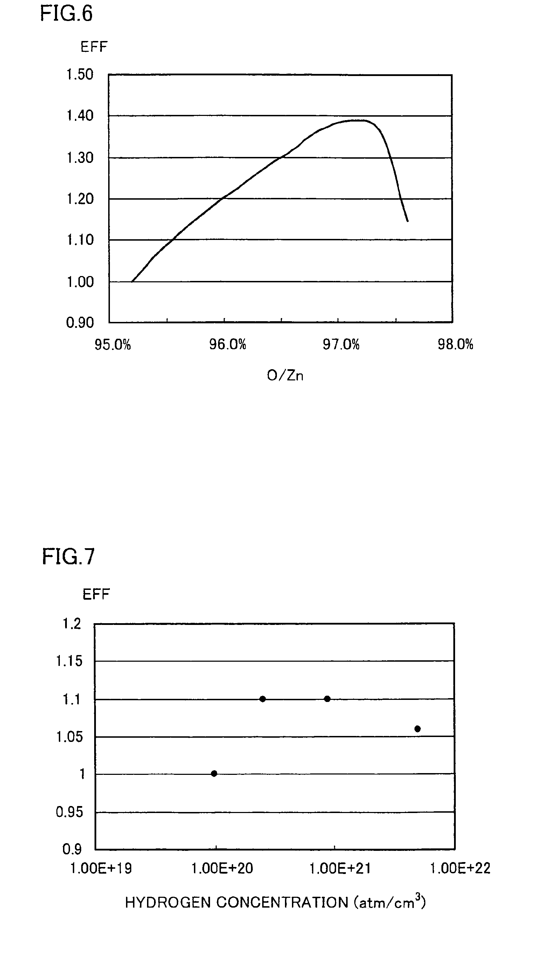

Conversion efficiency was evaluated by using each stack-type photovoltaic element manufactured in Examples 1 to 7 and Comparative Example 1 above. Evaluation conditions were such that irradiation at AM 1.5 and at light intensity of 100 mW/cm² was carried out with the use of a solar simulator and a measurement temperature was set to 25°C. Fig. 6 and Table 1 show results.

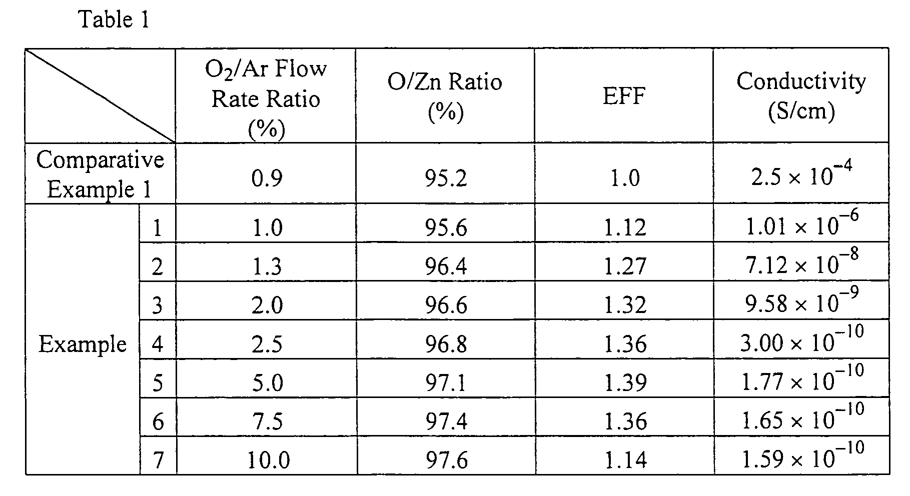

Table 1 shows representative measurement results of conversion efficiency with respect to an oxygen atom concentration/zinc atom concentration ratio (O/Zn) of the intermediate layer, and Fig. 6 is a graph showing variation in conversion efficiency with respect to the oxygen atom concentration/zinc atom concentration ratio (O/Zn) of the intermediate layer. It is noted that "photoelectric conversion efficiency" is denoted as "EFF".

In Table 1, in a case where the oxygen atom concentration/zinc atom concentration ratio was not lower than 95.6% and not higher than 97.6% (that is, not lower than 0.956 and not higher than 0.976) and satisfied the range according to the present invention, conversion efficiency improved as compared with Comparative Example 1 not satisfying such a range, and it improved to 1.1 time or more. In addition, it was shown that, in a case where the ratio was not lower than 0.964 and not higher than 0.974, conversion efficiency improved to 1.2 time or more and may further improve to approximately 1.4 time.

It is noted that a component (O/Zn) of the intermediate layer was confirmed in ICP-MS measurement. A single film composed of ZnO similar to the intermediate layer was deposited by 120 nm on a silicon wafer and this single film was immersed in 10 ml of EL-grade oxalic acid and eluted. A solution in which the single film had been eluted was diluted at factors of 1, 10, 100, 1000, and 10000 so as to prepare sample solutions, and measurement was conducted with the use of ICP-MS. It is noted that concentrations of the dopant components of the intermediate layer with respect to main element Zn concentration 100%, that is, concentrations of Mg, Al, K, and Cu, were 62.2 ppm, 43 ppm, 35.3 ppm, and 2.8 ppm, respectively. Thus, it was shown that introduction of the dopant components into the metal oxide representing the source material was not higher than 0.01 % as expressed in atomic ratio.

### (Measurement of Electrical Characteristics)

Each sample for electrical characteristic measurement was used to measure electrical characteristics of the single film. A specific method is as follows.

Namely, a single film composed of zinc oxide was deposited on the glass substrate which was #1373 (item number) manufactured by Coming Incorporated, under the conditions as in formation of the intermediate layer. This single film was used as the sample for electrical characteristic measurement. Parallel plate electrodes were attached to each single film and then a voltage-current characteristic was measured, and conductivity was found based on this result. Specifically, gap electrodes having a gap width of 250 µm and an electrode width of 5 mm were employed as the parallel plate electrodes by depositing Ag to a thickness of 100 nm through vacuum vapor deposition. A voltage was applied across the parallel plate electrodes (gap electrodes) by using 4140B Source Measurement Unit manufactured by HP, a current was observed, a voltage-current characteristic was measured, and conductivity was determined. Table 1 shows results.

### <Discussion 2>

### (Examples 8 to 10): Triple-Cell Structure, Hydrogen Concentration

A stack-type photovoltaic element was manufactured as in Example 1, except that the oxygen atom concentration/zinc atom concentration ratio of the intermediate layer was set to 97.4%, the p layer of the second photovoltaic element portion formed on the intermediate layer was formed of microcrystalline Si, and conditions in forming the p layer were set to conditions shown in Table 2.

Hydrogen concentration (hydrogen content) in the intermediate layer in the obtained stack-type photovoltaic element was found based on a result of measurement in secondary ion mass spectrometry (SIMS) using IMS 7f manufactured by CAMECA and using Cs⁺ ions. Conditions in measurement in secondary ion mass spectrometry (SIMS) were set to 3 keV and 10 nA and analysis in a direction of depth was conducted. Regarding identification of a zinc oxide film, since oxygen concentration in the zinc oxide film was not lower than 1 × 10²² atoms/cm³, the zinc oxide film was identified as the starting point of a ZnO layer and lowest concentration in the layer identified as the ZnO layer was defined as the hydrogen concentration in the ZnO layer. It is noted that hydrogen concentration in the intermediate layer in Examples 1 to 7 was each 8.9 × 10²⁰ atoms/cm³.

Fig. 7 and Table 2 show conversion efficiency at each hydrogen concentration. Conversion efficiency is shown as a relative value, with a value in a case where the p layer of the second photovoltaic element formed on the intermediate layer was composed of amorphous Si (in the table, a-Si) being assumed as 1. At the same time, series resistance Rₛ found based on an I-V characteristic is shown.

**Table 2**

| | a-Si | Example 8 | Example 9 | Example 10 |
|---|---|---|---|---|
| Hydrogen Dilution Factor (Fold) | 100 | 200 | 259 | 304 |
| Hydrogen Concentration (atm/cm³) | 9.8 × 10¹⁹ | 2.5 × 10²⁰ | 8.9 × 10²⁰ | 4.9 × 10²¹ |
| Series Resistance Rs (Ω•cm²) | 76 | 29 | 28 | 28 |
| Conversion Efficiency | 1.0 | 1.10 | 1.10 | 1.06 |

It was found from the results in Table 2 and Fig. 7 that, when the hydrogen concentration in the intermediate layer satisfied the range according to the present invention, that is, not lower than 2.5 × 10²⁰ atoms/cm³ and not higher than 4.9 × 10²¹ atoms/cm³, the photoelectric conversion efficiency was good. In addition, when the ratio of the flow rate of the hydrogen gas to the source gas (H₂ gas flow rate/SiH₄ gas flow rate = hydrogen dilution factor) in forming the p layer of the second photovoltaic element portion was 200 or higher, good photoelectric conversion efficiency (EFF) resulted. It is noted that, even though the oxygen atom concentration/zinc atom concentration ratio of the intermediate layer was varied in the range not lower than 95.6% and not higher than 97.6%, good results were similarly obtained.

### <Discussion 3>

### (Examples 11 to 16 and Comparative Example 2): Tandem Structure, Conductivity, and Sheet Resistance

In present Examples 11 to 16 and Comparative Example 2, a stack-type photovoltaic element having a tandem structure shown in Fig. 1 was fabricated.

Specifically, a pin-type photovoltaic element in which the i layer was composed of intrinsic amorphous Si hydride having a thickness of 250 nm and the p layer and the n layer were composed of microcrystalline Si was fabricated as the first photovoltaic element portion. A pin-type photovoltaic element in which the i layer was composed of intrinsic microcrystalline Si hydride having a thickness of 1.6 µm and the p layer and the n layer were composed of microcrystalline Si was fabricated as the second photovoltaic element portion. In addition, a stack-type photovoltaic element including zinc oxide (ZnO) of which dopant content was not higher than 0.01 % was fabricated as the intermediate layer. A stack-type photovoltaic element according to Comparative Example 2 was fabricated with a method similar to that in Examples 11 to 16, except that conductive characteristics of the intermediate layer did not satisfy the present invention.

### (Step of Forming First Electrode)

A glass substrate of #1373 (item number) manufactured by Coming Incorporated, having a size of 115 mm × 115 mm, was employed as the substrate. A 700-nm transparent conductive film composed of SnO₂ was formed as the first electrode on this glass substrate with sputtering.

### (Step of Stacking First Photovoltaic Element Portion)

The first photovoltaic element portion was formed on the substrate on which the first electrode had been formed, with the use of the multi-chamber-type plasma CVD apparatus.

Specifically, initially, the p layer composed of microcrystalline Si was formed. The p layer was formed with a method similar to the method of forming the p layer of the first pin structure in Example 1, except that a flow rate of the hydrogen gas to the silane gas was set to 100 times higher and power density per unit area of the cathode electrode was set to 0.25 W/cm³. Feed of electric power was stopped when the p layer reached a thickness of 25 nm. Thereafter, the first film formation chamber was evacuated to produce vacuum therein.

Then, the i layer composed of amorphous Si hydride was formed. The i layer was formed with a method similar to that for the p layer except that the second film formation chamber was used, a gas mixture of the silane gas and the hydrogen gas was used as the gas mixture to be introduced into the film formation chamber, and a flow rate of the hydrogen gas to the silane gas was set to 10 times higher. Supply of electric power was stopped when the i layer reached a thickness of 250 nm and the second film formation chamber was evacuated.

Then, the n layer composed of microcrystalline Si was formed. The n layer was formed with a method similar to that for the p layer above except that the third film formation chamber was used, a gas mixture of the silane gas, the hydrogen gas, and the phosphine gas was used as the gas mixture to be introduced into the film formation chamber, and a flow rate of the hydrogen gas to the silane gas was set to 100 times higher. Supply of electric power was stopped when the n layer reached a thickness of 25 nm and thereafter the film formation chamber was evacuated.

Through the steps above, the pin-type first photovoltaic element portion including the i layer serving as the photoelectric conversion layer and composed of amorphous Si hydride was formed.

### (Step of Stacking Intermediate Layer)

The substrate on which the first photovoltaic element portion had been formed was installed on a substrate holder of a DC magnetron sputtering apparatus and a reaction chamber of the DC magnetron sputtering apparatus was evacuated until the pressure therein was set to 10⁻⁴ Pa or lower. After the substrate was heated for 20 minutes to a temperature of 150°C, the argon gas was supplied at 100 sccm, and at the same time, the oxygen gas was supplied from the gas introduction portion provided in the DC magnetron sputtering apparatus at a ratio of a flow rate of the oxygen gas to the argon gas in accordance with Table 4 which will be described later.

DC electric power of 280 W was applied from a DC sputtering power supply to a target composed of non-doped zinc oxide (ZnO) not containing a dopant component and having purity of 4 N. Sputtering was carried out while a speed of carrying the substrate was adjusted such that a thickness of the intermediate layer formed at each flow rate of the oxygen gas was equal and the intermediate layer composed of zinc oxide (ZnO) having a thickness of approximately 45 nm was deposited. This intermediate layer was each transparent.

In forming this intermediate layer, at the same time, a glass substrate of #1373 (item number) manufactured by Coming Incorporated, having a size of 115 mm × 115 mm, was installed on a substrate holder in the reaction chamber above, and a film composed of zinc oxide (ZnO) similar to the intermediate layer (a film thickness of 45 nm) was deposited to thereby make a sample for electrical characteristic measurement. Conditions for forming the intermediate layer are shown in Table 3. It is noted that, other than samples fabricated simultaneously with fabrication of the intermediate layers according to Examples 11 to 16 and Comparative Example 2, samples for electrical characteristic measurement were fabricated under conditions satisfying the conditions in Table 3 below.

**Table 3**

| Intermediate Layer Formation Condition 1 | |
|---|---|
| Substrate Heating Temperature | 150°C |
| Substrate Heating Time Period | 20 minutes |
| Argon Gas Flow Rate | 100 sccm |
| Oxygen Gas Flow Rate | 0-14 sccm |
| DC Electric Power | 280 W |
| Film Formation Pressure | 0.6 Pa |

### (Step of Exposure to Plasma Containing Hydrogen)

In the step of exposure to plasma containing hydrogen, treatment was performed under such gas conditions that SiH₄ was excluded from the p layer formation conditions for the second photovoltaic element portion which will be described later, the second photovoltaic element portion being formed after deposition of the intermediate layer composed of ZnO.

### (Step of Stacking Second Photovoltaic Element Portion)

The second photovoltaic element portion was stacked on the intermediate layer after exposure to plasma containing hydrogen. A condition for forming the second photovoltaic element portion was set to a microcrystal condition. Namely, the p layer was formed on the intermediate layer with a formation method similar to that for the p layer in the first photovoltaic element portion, the i layer composed of microcrystalline Si hydride was then formed, and then the n layer was formed with a formation method similar to that for the n layer in the first photovoltaic element portion.

### (Step of Forming Second Electrode)

A 0.2-µm second electrode composed of Ag was formed on the second photovoltaic element portion to thereby manufacture the stack-type photovoltaic element. Such a stack-type photovoltaic element had an integrated structure, which was a three-tiered integrated cell in which a single cell was of 1-cm square. Specifically, as shown in Fig. 5, it is an integration of first isolation groove 15/contract line 16/second isolation groove 17 structures.

A three-tiered integrated module having a cell width of 20 mm and an integration pitch of 11 mm was cut from the fabricated stack-type photovoltaic element and characteristics of the element were evaluated.

### (Measurement of Electrical Characteristics)

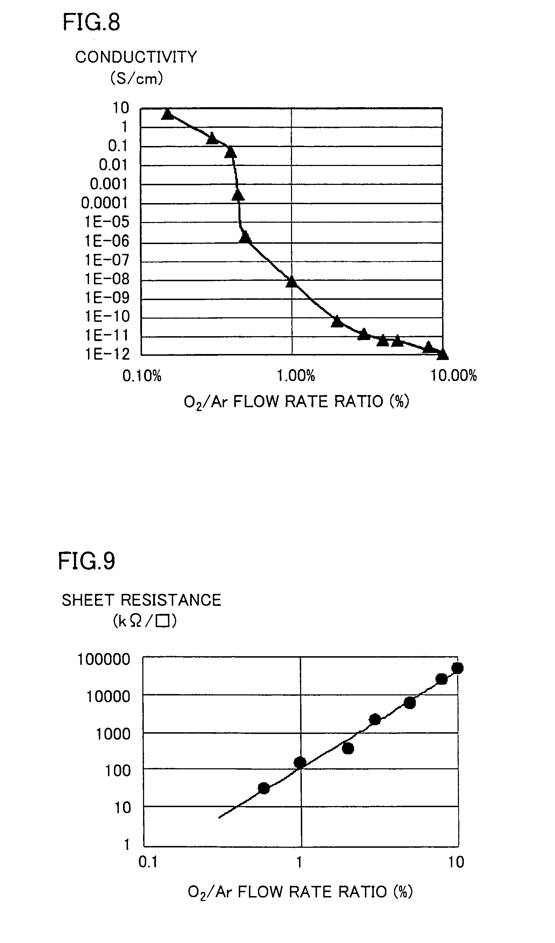

In order to know electrical characteristics of the intermediate layer in the stack-type photovoltaic element, each sample for electrical characteristic measurement above was used to measure electrical characteristics of a single film, and conductivity of the intermediate layer was found from the results. Specific measurement method is the same as in Example 1. Fig. 8 and Table 4 show relation between conductivity in an in-plane direction in the single film of the intermediate layer and a ratio of a flow rate of oxygen to the argon gas.

**Table 4**

| | | Comparative Example 2 | Example 11 | Example 12 | Example 13 | Example 14 | Example 15 | Example 16 |
|---|---|---|---|---|---|---|---|---|
| Intermediate Layer ZnO Thickness (nm) | | 45 | 45 | 45 | 45 | 45 | 45 | 45 |
| O₂/Ar | | 0.6 | 1 | 2 | 3 | 5 | 8 | 10 |
| O₂ Partial | Pressure (Pa) | 0.004 | 0.006 | 0.01 | 0.02 | 0.03 | 0.04 | 0.05 |
| Conductivity (S/cm) | Before Plasma Treatment | 3 × 10⁻³ | 8.37 × 10⁻⁹ | 6.7 × 10⁻¹¹ | 1.41 × 10⁻¹¹ | 5.59 × 10⁻¹² | 2.59 × 10⁻¹² | 1.18 × 10⁻¹² |
| | After Plasma Treatment | 7,17 | 1.48 | 6.54 × 10⁻¹ | 1.03 × 10⁻¹ | 3.75 × 10⁻² | 8.78 × 10⁻³ | 4.43 × 10⁻³ |
| Sheet Resistance (kΩ/□) | Before Plasma Treatment | 7.41 × 10⁴ | 2.65 × 10¹⁰ | 3.32 × 10¹² | 1.58 × 10¹³ | 3.98 × 10¹³ | 8.58 × 10¹³ | 1.88 × 10¹⁴ |
| | After Plasma Treatment | 31 | 150 | 340 | 2157 | 5920 | 25310 | 50210 |
| Conversion Efficiency | | 1.00 | 1.20 | 1.29 | 1.29 | 1.27 | 1.24 | 1.14 |

It was found from the results in Fig. 8 that, by carrying out DC sputtering using a target composed of non-doped zinc oxide (ZnO) not containing a dopant component and having purity of 4 N and by varying the ratio of the flow rate of the oxygen gas to the argon gas within the range shown in Table 3, conductivity of the single film could be varied from 10 S/cm to 1 × 10⁻¹² S/cm. In addition, it was found that, by finding such a calibration curve, desired conductivity could be achieved by varying the ratio of the flow rate of the oxygen gas to the argon gas by using the target above.

In addition, it was found from the results in Table 4 that conversion efficiency of the manufactured stack-type photovoltaic element improved by setting the ratio of the flow rate of the oxygen gas to the argon gas to 1% or higher and 10% or lower.

Moreover, sheet resistance of each sample among the samples for electrical characteristic measurement above, that was deposited at the O₂/Ar flow rate ratio as in Examples 11 to 16 and Comparative Example 2, was measured. Further, after each sample was subjected to the step of exposure to plasma containing hydrogen with a method similar to that in Examples 11 to 16 and Comparative Example 2, an electrical characteristic (sheet resistance) of each sample was measured. Sheet resistance was carried out by using Hiresta UP MCP-HT450 manufactured by Mitsubishi Chemical Corporation. Fig. 9 shows relation between the sheet resistance of the single film of the intermediate layer after plasma treatment and the ratio of the flow rate of the oxygen gas to the argon gas. Furthermore, Table 4 shows conductivity and sheet resistance of the intermediate layer before and after plasma treatment.

As shown in Fig. 9, it was found that sheet resistance of the intermediate layer varied depending of the ratio of the flow rate of the oxygen gas to the argon gas (or the oxygen partial pressure) during formation of the intermediate layer composed of ZnO. From such results, it was considered that, by including the step of exposure to plasma containing hydrogen, hydrogen radicals permeated into ZnO and thus resistance of the intermediate layer composed of ZnO was lowered.

Table 5 shows results of measurement of a sheet resistance value of the intermediate layer composed of ZnO, after the step of exposure to plasma containing hydrogen under such a condition that a silicon-based film was not deposited, with a plasma condition being varied in correspondence with a condition for forming a p layer to subsequently be formed.

Specifically, a sample, for which a 45-nm intermediate layer composed of ZnO had been deposited on the glass substrate of #1373 (item number) manufactured by Coming Incorporated and thereafter the step of exposure to plasma containing hydrogen under a condition with SiH₄ having been excluded from the conditions for forming a microcrystalline p layer had been performed, was prepared. In addition, a sample, for which a 45-nm intermediate layer composed of ZnO had been deposited on the glass substrate above and thereafter the step of exposure to plasma containing hydrogen under a condition with SiH₄ having been excluded from the conditions for forming an amorphous p layer had been performed, was prepared. Then, a sheet resistance value of each sample was measured.

**Table 5**

| Condition | Sheet Resistance (kΩ/□) |
|---|---|
| Microcrystal Condition | 38.5 |
| Amorphous Condition | 109 |
| Amorphous Layer 10 nm + Microcrystal Condition | 6470 |

It was found from the results in Table 5 that lowering in resistance of the intermediate layer was mitigated by varying the condition for forming the p layer in the second photovoltaic element portion from a condition for forming microcrystal to a condition for forming amorphous. Therefore, it was found that permeation of hydrogen into ZnO lowered resistance of ZnO.

In addition, Table 5 shows sheet resistance of a sample subjected to the step of exposure to plasma containing hydrogen, under a condition with SiH₄ having been excluded from the conditions for forming microcrystal after depositing an amorphous layer by 10 nm on the intermediate layer. It was found from this result that, by depositing amorphous silicon on a ZnO interface, in spite of irradiation with plasma of hydrogen, resistance was higher than in treatment under a condition for forming amorphous. It was thus considered that resistance of ZnO varied due to irradiation of ZnO with plazma at an early stage of deposition of a silicon film at the ZnO interface.

It is noted that a component in the intermediate layer (O/Zn) in Examples 11 to 16 and Comparative Example 2 was confirmed in ICP-MS measurement. A specific measurement method is the same as in Example 1. Concentrations of Mg, Al, K, and Cu with respect to main element Zn concentration 100% were 62.2 ppm, 43 ppm, 35.3 ppm, and 2.8 ppm, respectively. Thus, it was shown that, in the intermediate layer according to the present invention, the dopant components as mixed in the metal oxide representing the source material were not higher than 0.01 % as expressed in atomic ratio.

### (Evaluation of Conversion Efficiency)

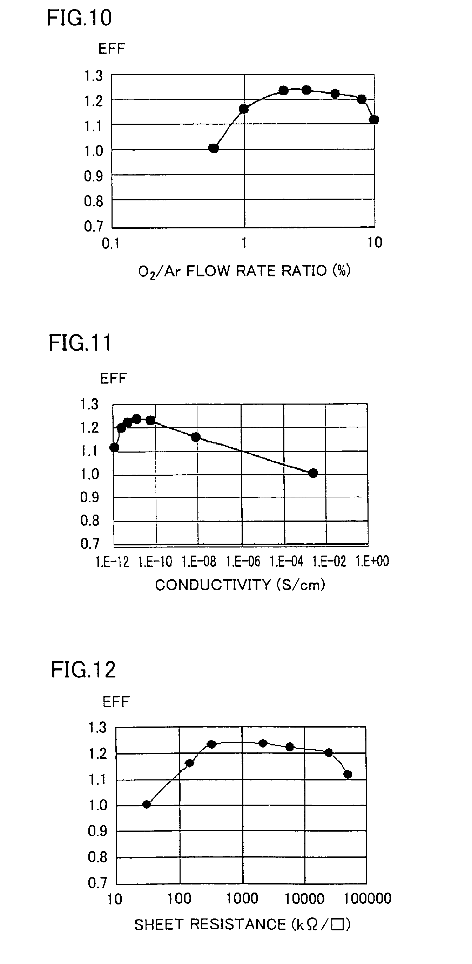

Conversion efficiency was evaluated by using each stack-type photovoltaic element manufactured in Examples 11 to 16 and Comparative Example 2 above. Evaluation conditions were the same as in Example 1. Fig. 10 and Table 4 show the results. It is noted that plotting was made in Figs. 10 to 12, assuming the conversion efficiency in Comparative Example 2 in Table 4 being defined as 1.

As shown in Figs. 10 to 12 and Table 4, it was found that, in a case where sheet resistance of the single film after sputtering, that is, after plasma treatment, was in a range lower than 100 kΩ/□ as in the invention disclosed, for example, in PTL 1 above, conversion efficiency did not improve but lowered. It was found that this was because of occurrence of shunt leakage in a process for manufacturing a photovoltaic element and in a state where the element was used after manufacturing. In addition, it was found that conversion efficiency lowered due to series resistance, also in a case where the sheet resistance was not lower than 100 MΩ/□.

On the other hand, regarding the stack-type photovoltaic element according to the present invention, the intermediate layer having prescribed characteristics is subjected to the step of exposure to plasma containing hydrogen and characteristics of the obtained intermediate layer are set in the specific range. Therefore, as shown in Fig. 10 and Table 4, an element having further improved conversion efficiency, for example, having conversion efficiency 1.1 time or more or 1.29 time as high as photoelectric conversion efficiency in Comparative Example 2 is obtained. It was shown that the present invention could improve efficiency of an element with an extremely easy manufacturing method.

Fig. 11 shows conversion efficiency with respect to conductivity before plasma treatment, and Fig. 12 shows conversion efficiency with respect to sheet resistance before plasma treatment. Conversion efficiency was plotted as in Fig. 10, with conversion efficiency in Comparative Example 2 being defined as 1. It was shown from the results in these Figs. 10 to 12 that photoelectric efficiency could be improved as compared with a conventional example when the intermediate layer had the prescribed characteristics according to the present invention.

It is noted that conductivity of the intermediate layer according to the present invention corresponds to 10¹³ to 2 × 10¹⁷ Ω/□, as converted to sheet resistance of the single film in an as-depo state, that is, immediately after formation of the intermediate layer and before hydrogen plasma treatment.

### <Discussion 4>

### (Example 17): Tandem Structure, N-Layer Amorphous Silicon

In present Example 17, a stack-type photovoltaic element was manufactured with a method similar to that in Example 11 above, except that the n layer of the first photovoltaic element portion in contact with the intermediate layer was composed of amorphous silicon.

Conditions for forming the n layer in the first photovoltaic element portion from amorphous silicon are as follows. An internal pressure in the first film formation chamber was set to 400 Pa. A gas mixture containing the silane gas, the hydrogen gas, and the diborane gas was employed as the gas mixture to be introduced into the first film formation chamber. In the gas mixture above, a flow rate of the hydrogen gas to the silane gas was set to 10 times higher.

After the gas mixture above was introduced and the pressure in the first film formation chamber became stable, AC electric power of 13.56 MHz was fed to the cathode electrode to generate plasma between the cathode electrode and the anode electrode. This plasma formed the n layer. Power density per unit area of the cathode electrode was set to 0.05 W/cm². The n layer had a thickness of 25 nm.

Photoelectric conversion efficiency of the stack-type photovoltaic element in Example 17 was measured. In addition, a single film similar to the n layer formed in the first photovoltaic element portion was formed on the glass substrate above to a thickness of 150 nm with a method similar to that in fabricating the sample for electrical characteristic measurement in Example 11, and electrical characteristics of this single film were evaluated. Further, hydrogen content and crystallinity of this single film were measured. Conductivity of the n-layer amorphous silicon of this single film was 1.26 × 10⁻² S/cm, hydrogen content was 12%, and crystallinity was 0.52.

Photoelectric conversion efficiency, conductivity, and hydrogen content (hydrogen concentration) were measured with a method the same as in Example 11. Crystallinity was calculated by utilizing Raman scattering spectrum. Crystallinity herein refers to a ratio of a peak height Ic at 520 cm⁻¹ attributed to silicon-silicon bond in crystalline silicon with respect to a peak height Ia of amorphous silicon at 480 cm⁻¹, that is, Ic/Ia, in Raman scattering spectrum of a single layer of a semiconductor layer.

It is noted that conductivity of n-layer microcrystal of the single film in the first photovoltaic element portion in Example 11 was 1.75 × 10¹ S/cm, hydrogen content was 4%, and crystallinity was 3.4.

**Table 6**

| | Example 11 (n-Layer Crystal Condition) | Example 17 (n-Layer Amorphous Condition) |
|---|---|---|
| Conversion Efficiency | 1.78 | 1.00 |

As shown in Table 6, even though the n layer in contact with the intermediate layer of the first photovoltaic element portion was composed of amorphous silicon, conversion efficiency could be improved as compared with a conventional element. In addition, as compared with a case where the n layer in contact with the intermediate layer of the first photovoltaic element portion was composed of microcrystalline silicon as in Example 11, the ZnO interface of the intermediate layer was relatively high in resistance and contact thereof was thus poor, and hence poor characteristics resulted. Namely, it can be concluded that a case where the n layer in contact with the intermediate layer was composed of microcrystalline silicon as in Example 11 was preferred.

### <Discussion 5>

### (Example 18): Triple-Cell Structure

In Example 18, a stack-type photovoltaic element having a triple-cell structure was fabricated. This construction was the same as that of stack-type photovoltaic element 300 described in the second embodiment. Except that the stack-type photovoltaic element had a triple structure, the step of stacking the intermediate layer and the step of exposure to plasma containing hydrogen were similar to those in Example 11.

Specifically, a pin-type photovoltaic element in which the i layer was composed of intrinsic amorphous Si hydride was fabricated as the first pin structure. In addition, a pin-type photovoltaic element in which the i layer was composed of intrinsic amorphous Si hydride was fabricated as the second pin structure. Further, a pin-type photovoltaic element in which the i layer was composed of intrinsic microcrystalline Si was fabricated as the second photovoltaic element portion.

### (Step of Forming First Electrode)

A 700-nm first electrode composed of SnO₂ was formed with the use of a large-sized substrate of 1000 mm × 600 mm, as in Example 11.

### (Step of Stacking First Photovoltaic Element Portion)

The first photovoltaic element portion constituted of the first pin structure and the second pin structure was manufactured on the substrate on which the first electrode had been formed.

The first pin structure was manufactured with a method similar to the method of forming a pin-type photovoltaic element constituting the first photovoltaic element portion in the first embodiment. Specifically, the p layer composed of amorphous Si hydride, the i layer composed of intrinsic amorphous Si hydride, and the n layer composed of amorphous Si hydride were formed.

The second pin structure was manufactured with a method similar to the method of forming the first photovoltaic element portion in Example 11. Specifically, the p layer composed of microcrystalline Si, the i layer composed of intrinsic amorphous Si hydride, and the n layer composed of microcrystalline Si were formed. The i layer had a thickness of 0.5 µm. The first photovoltaic element portion was manufactured as above.

### (Step of Stacking Intermediate Layer)

The glass substrate above on which the first photovoltaic element portion had been formed was installed on a substrate holder of a DC magnetron sputtering apparatus and a reaction chamber of the DC magnetron sputtering apparatus was evacuated until the pressure therein was set to 10⁻⁴ Pa or lower. After heating was carried out such that a substrate temperature attained to 150°C while carrying the substrate, the argon gas at 150 sccm and the oxygen gas were supplied from the gas introduction portion at such a flow rate as satisfying the ratio of the flow rate of the oxygen gas to the argon gas in Table 7. In addition, the pressure during formation of the intermediate layer was also regulated in the range shown in Table 7.

DC electric power of 11.7 kW was applied from a DC sputtering power supply to a target composed of non-doped zinc oxide (ZnO) not containing a dopant component and having purity of 4 N. Sputtering was carried out while a carrying speed was adjusted such that a thickness of a film formed under each gas flow rate ratio condition was equal and the intermediate layer composed of zinc oxide (ZnO) having a thickness of approximately 75 nm was formed.

In forming this intermediate layer, at the same time, a glass substrate of #1373 (item number) manufactured by Coming Incorporated, having a size of 115 mm × 115 mm, was installed on a substrate holder in the reaction chamber above, and a film composed of zinc oxide (ZnO) similar to the intermediate layer (a film thickness of 75 nm) was deposited to thereby make a sample for electrical characteristic measurement. Table 7 shows conditions for forming the intermediate layer (intermediate layer formation condition 2).

**Table 7**

| Intermediate Layer Formation Condition 2 | |
|---|---|
| Substrate Heating Temperature | 150°C |
| Substrate Heating Time Period | 20 minutes |
| Argon Gas Flow Rate | 400 sccm |
| Oxygen Gas Flow Rate | 0-100 sccm |
| DC Electric Power | 11.7 W |
| Film Formation Pressure | 0.05-0.52 Pa |

### (Step of Stacking Second Photovoltaic Element, Also Serving as Step of Exposure to Plasma Containing Hydrogen)

Then, a pin-type photovoltaic element in which the p layer, the i layer, and the n layer were composed of microcrystalline Si hydride was fabricated as the second photovoltaic element portion on the substrate on which a transparent intermediate layer had been formed, by using a known film formation apparatus.

Thereafter, the second electrode was formed to fabricate the stack-type photovoltaic element having the triple-cell structure. A three-tiered integrated module having a cell width of 20 mm and an integration pitch of 11 mm was cut from the fabricated stack-type photovoltaic element having a size of 1000 mm × 600 mm and characteristics of the element were evaluated.

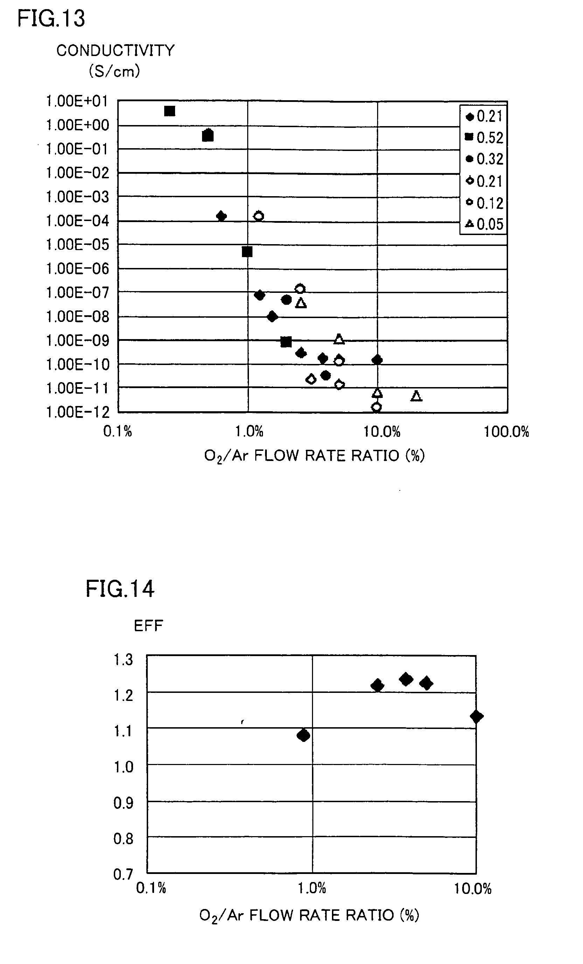

Conductivity of the single film before plasma treatment of the sample for electrical characteristic measurement was measured. Fig. 13 shows variation in conductivity before plasma treatment with respect to an O₂/Ar flow rate ratio. In Fig. 13, different plot shapes were shown for each single film formation pressure. A film formation pressure corresponding to each plot shape is shown in the upper right portion of the graph in Fig. 13.

As shown in Fig. 13, regardless of a film formation pressure, as the ratio of the flow rate between the oxygen gas and the argon gas (the O₂/Ar flow rate ratio) is higher, conductivity tends to be low. In addition, it was found that, when the ratio of the flow rate of the oxygen gas to the argon gas was not lower than 2%, lowering in conductivity became gentler, and when the ratio of the flow rate of the oxygen gas to the argon gas was in a range not lower than 2% and not higher than 10%, conductivity approximately from 1 × 10⁻⁸ to 2 × 10⁻¹² S/cm was obtained.

Moreover, Fig. 14 shows variation in conversion efficiency with respect to an O₂/Ar flow rate ratio in the stack-type photovoltaic element having the triple-cell structure obtained in the present example. It is noted that Fig. 14 shows conversion efficiency of the stack-type photovoltaic element having the intermediate layer formed at a film formation pressure of 0.21 Pa in the present example. As shown in Fig. 14, it was found that good conversion efficiency was obtained by including the intermediate layer according to the present invention, also in the triple-cell structure.

### <Discussion 6>

### (Example 18): Triple-Cell Structure, Intermediate Layer Thickness

A stack-type photovoltaic element having a triple-cell structure was fabricated by using a large-sized substrate of 1000 mm × 600 mm. A thickness of the intermediate layer was adjusted in a range from 0 nm to 200 nm by varying DC power (DC electric power in Table 8). Table 8 shows conditions for forming the intermediate layer (intermediate layer formation condition 3). Other conditions are the same as in Example 17.

**Table 8**

| Intermediate Layer Formation Condition 3 | |
|---|---|
| Substrate Heating Temperature | 150°C |
| Substrate Heating Time Period | 20 minutes |
| Argon Gas Flow Rate | 400 sccm |
| Oxygen Gas Flow Rate | 10 sccm |
| DC Electric Power | 3 kW - 20 kW |
| Film Formation Pressure | 0.21 Pa |

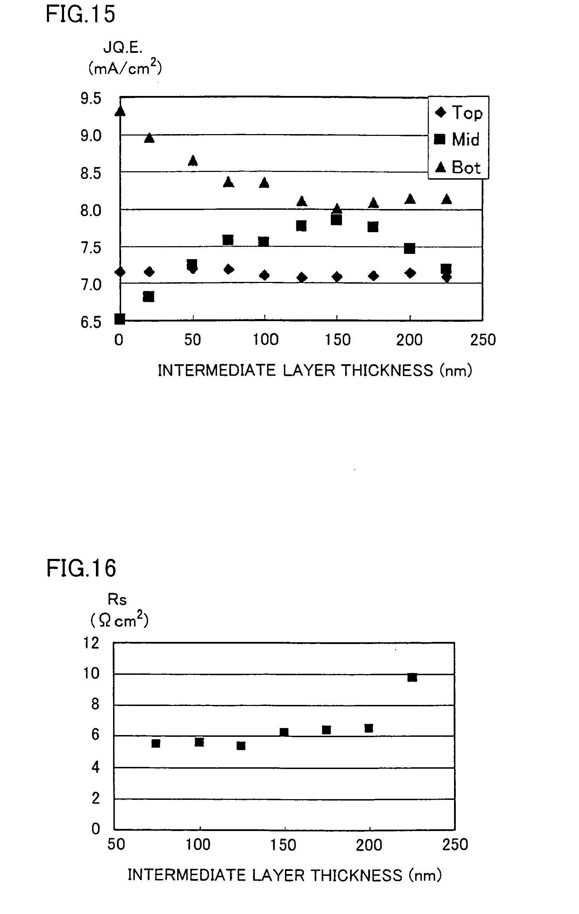

Electrical characteristics of the stack-type photovoltaic elements different in thickness of the intermediate layer were evaluated. Figs. 15 and 16 show results.

Fig. 15 is a graph showing relation between a thickness of the intermediate layer and a current in the photovoltaic element. As shown in Fig. 15, it was found that a middle current (Mid in Fig. 15) which was a current in the photovoltaic element constituted of the second pin structure included in triple cells increased with increase in thickness of the intermediate layer, and when the intermediate layer exceeded 150 nm, the middle current decreased due to interference effects. On the other hand, it was found that a bottom current (Bot in Fig. 15) which was a current in the second photovoltaic element portion also decreased with the increase in thickness of the intermediate layer. Further, it was found that a top current (Top in Fig. 15) which was a current in the photovoltaic element constituted of the first pin structure was a current on the light incident side and it was less likely to be affected by the intermediate layer. In light of such behaviors, it can be concluded that the total current in the stack-type photovoltaic element decreases if the intermediate layer has too great a thickness. It is noted that each current was measured with a spectral sensitivity measurement apparatus manufactured by JASCO Corporation.

Fig. 16 is a graph showing variation in series resistance with respect to a thickness of the intermediate layer. Series resistance (Ωcm²) was determined by measuring I-V characteristics in the stack-type photovoltaic element having the intermediate layer having each thickness.

As shown in Fig. 16, increase in series resistance with increase in thickness over 200 nm was observed. Though detailed reasons why such increase in resistance was observed are unclear, it is considered that distribution of conductivity in a direction of depth in a process in which resistance of the ZnO layer lowers depending on depth of permeation of hydrogen in the ZnO layer led to increase in series resistance. It is found from Fig. 16 that the intermediate layer desirably has a thickness not smaller than 20 nm and not greater than 200 nm.

### <Discussion 7>

### (Reference Example 1)

A stack-type photovoltaic element having a tandem structure was manufactured as Reference Example 1 as in Example 14 except for not having an intermediate layer, and conversion efficiency thereof was found.

### (Comparative Example 3)

A stack-type photovoltaic element was manufactured as in Example 14 by using ZnO doped with 3% Al (conductivity: 1 × 10⁻² S/cm) instead of non-doped ZnO for an intermediate layer having a thickness of 100 nm. In order to prevent the intermediate layer from displacing in a lateral direction, a scribe (an isolation groove) was provided in the intermediate layer with the use of laser after the intermediate layer was deposited, to thereby obtain the structure disclosed in Fig. 2 of Japanese Patent Laying-Open No. 2002-261308. In addition, an integrated structure in which 48 cells were connected in series was prepared.

Table 9 shows photoelectric conversion efficiency of each stack-type photovoltaic element in Example 14, Reference Example 1, and Comparative Example 3.

**Table 9**

| | Conversion Efficiency |
|---|---|
| Reference Example 1 (Without Intermediate Layer) | 1.00 |
| Comparative Example 3 (Intermediate Layer ZnO:Al) | 0.99 |
| Example 14 | 1.10 |

Assuming that conversion efficiency in Reference Example 1 is defined as 1, regarding Example 14, Reference Example 1, and Comparative Example 3, a current improved and conversion efficiency improved in Example 14. On the other hand, it was found that Comparative Example 3 in which low-resistance ZnO had been used for the intermediate layer was low in conversion efficiency in some cases, in spite of scribes having been provided. This may be caused because, in an element including a large-area substrate, there were relatively a large number of point leakages and hence point leakages in a top-side cell and a bottom-side cell with the intermediate layer lying therebetween conduct to each other through the intermediate layer (flow in a direction of a surface of the film).

On the other hand, it can be concluded that, in the stack-type photovoltaic element to which the intermediate layer having the prescribed characteristics according to the present invention were applied, since the intermediate layer is higher in resistance than the conventional example, a leakage current through point leakage is suppressed and high efficiency is obtained. Therefore, it was found that the present invention was optimal in particular for a large-sized cell adopting an integrated structure.

### <Discussion 8>

### (Example 19): Triple-Cell Structure, Intermediate Layer in Two-Layered Structure

A stack-type photovoltaic element having a triple-cell structure was fabricated with a method as in Example 5, except for difference in the step of stacking the intermediate layer. A method of stacking the intermediate layer in the present example is as follows.

A glass substrate on which components up to the first photovoltaic element portion had been fabricated was installed on a substrate holder of a DC magnetron sputtering apparatus and a reaction chamber of the DC magnetron sputtering apparatus was evacuated until the pressure therein was set to 10⁻⁴ Pa or lower. After heating was carried out such that a substrate temperature attained to 150°C while carrying the substrate, an argon gas was set to 400 sccm and supplied from the gas introduction portion such that the ratio of the flow rate of the oxygen gas to the argon gas was adjusted to 1%. The first intermediate layer was thus stacked on the first photovoltaic element portion. The first intermediate layer had a thickness of 125 nm. Then, the second intermediate layer was stacked on the first intermediate layer, with the ratio of the flow rate of the oxygen gas to the argon gas being adjusted to 5%. The second intermediate layer had a thickness of 125 nm. Through the operations above, the intermediate layer having a two-layered structure and a thickness of 250 nm was formed. In addition, a stack-type photovoltaic element as Comparative Example 3 was fabricated with a method as in Example 5, except that the intermediate layer had a thickness of 250 nm.

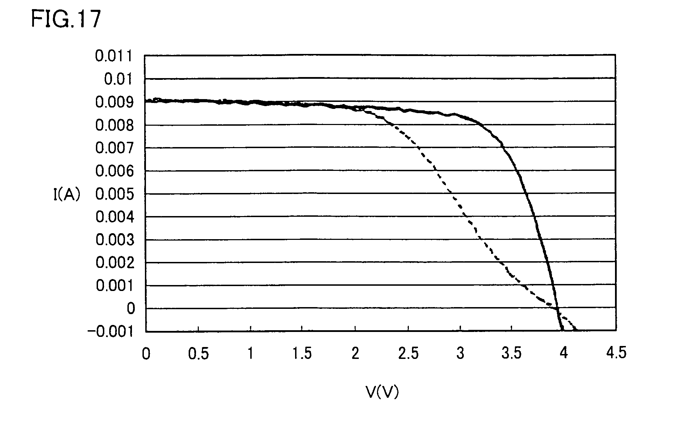

In forming the intermediate layer in Example 19 and Comparative Example 3, at the same time, a glass substrate of #1373 (item number) manufactured by Coming Incorporated, having a size of 115 mm × 115 mm, was installed on a substrate holder in the reaction chamber above, and a film identical to the intermediate layer was deposited to thereby make a sample for electrical characteristic measurement. Parallel electrodes were formed on a surface of this sample, a current when a voltage was applied across the parallel electrodes was measured, and thus voltage-current characteristics were calculated. Fig. 17 shows results.

In Fig. 17, a doted line represents voltage-current characteristics in Comparative Example 3 and a solid line represents voltage-current characteristics in Example 19. It was found from the results in Comparative Example 3 that a greater thickness of the intermediate layer having a single-layered structure led to increase in series resistance and poor voltage-current characteristics. In contrast, it was found that poor voltage-current characteristics could be overcome by making the intermediate layer as the two-layered structure as in Example 19, more specifically a structure in which a low-resistance first intermediate layer and a high-resistance second intermediate layer were formed from the substrate side. In addition, it was found that, when sheet resistance of each sample was measured, the samples were equal in sheet resistance value. Further, it was also found that shunt resistance increased in Example 19.

Though the embodiments and the examples of the present invention have been described above, combination of features in each embodiment and example described above as appropriate is also originally intended.

It should be understood that the embodiments and the examples disclosed herein are illustrative and non-restrictive in every respect. The scope of the present invention is defined by the terms of the claims, rather than the description above, and is intended to include any modifications within the scope and meaning equivalent to the terms of the claims.

### REFERENCE SIGNS LIST

1 substrate; 2 first electrode; 3 first photovoltaic element portion; 3a p layer; 3b i layer; 3c n layer; 5 second photovoltaic element portion; 5a p layer; 5b i layer; 5c n layer; 6 second electrode; 6a transparent conductive film; 6b metal film; 7 intermediate layer; 7a first intermediate layer; 7b second intermediate layer; and 100, 300 stack-type photovoltaic element.

## Claims

1. A stack-type photovoltaic element (100) in which a first photovoltaic element portion (3) and a second photovoltaic element portion (5) are successively stacked from a substrate (1) side, comprising:
at least one intermediate layer (7) between said first photovoltaic element portion (3) and said second photovoltaic element portion (5),
said intermediate layer (7) being formed from a metal oxide film having an oxygen atom concentration/metal atom concentration ratio not lower than 0.956 and not higher than 0.976.

2. A stack-type photovoltaic element (100) in which a first photovoltaic element portion (3) and a second photovoltaic element portion (5) are successively stacked from a substrate (1) side, comprising:
at least one intermediate layer (7) between said first photovoltaic element portion (3) and said second photovoltaic element portion (5),
said intermediate layer (7) being formed from a metal oxide film having hydrogen atom concentration not lower than 2.5 × 10²⁰ atoms/cm³ and not higher than 4.9 × 10²¹ atoms/cm³.

3. A stack-type photovoltaic element (100) in which a first photovoltaic element portion (3) and a second photovoltaic element portion (5) are successively stacked from a substrate (1) side, comprising:
at least one intermediate layer (7) between said first photovoltaic element portion (3) and said second photovoltaic element portion (5),
the intermediate layer (7) being formed from a metal oxide film having an oxygen atom concentration/metal atom concentration ratio not lower than 0.956 and not higher than 0.976 and hydrogen atom concentration not lower than 2.5 × 10²⁰ atoms/cm³ and not higher than 4.9 × 10²¹ atoms/cm³.

4. The stack-type photovoltaic element (100) according to any of claims 1 to 3, wherein
said intermediate layer (7) has a first intermediate layer (7a) arranged on said first photovoltaic element portion (3) and a second intermediate layer (7b) arranged on said first intermediate layer (7a), and said second intermediate layer (7b) is higher in oxygen atom concentration/metal atom concentration ratio than said first intermediate layer (7a).

5. The stack-type photovoltaic element (100) according to claim 4, wherein said second intermediate layer (7b) is lower in hydrogen atom concentration than said first intermediate layer (7a).

6. A stack-type photovoltaic element (100) in which a first photovoltaic element portion (3) and a second photovoltaic element portion (5) are successively stacked from a substrate (1) side, comprising:
at least one intermediate layer (7) between said first photovoltaic element portion (3) and said second photovoltaic element portion (5),
said intermediate layer (7) being formed from a metal oxide film having sheet resistance not lower than 100 kΩ/□ and not higher than 26 MΩ/□.

7. A stack-type photovoltaic element (100) in which a first photovoltaic element portion (3) and a second photovoltaic element portion (5) are successively stacked from a substrate (1) side, comprising:
at least one intermediate layer (7) between said first photovoltaic element portion (3) and said second photovoltaic element portion (5),
said intermediate layer (7) being formed of metal oxide having conductivity of a single film not lower than 2 × 10⁻¹² S/cm and not higher than 1 × 10⁻⁸ S/cm.

8. The stack-type photovoltaic element (100) according to any of claims 1 to 7, wherein
a p layer (5a) included in said second photovoltaic element portion (5) is formed under such a condition that a dilution factor of a source gas with a hydrogen gas is 200 or higher.

9. The stack-type photovoltaic element (100) according to any of claims 1 to 8, having an integrated structure.

10. A method of manufacturing a stack-type photovoltaic element (100), comprising the steps of:
stacking a first photovoltaic element portion (3) including at least one photovoltaic element on a substrate (1);
stacking on said first photovoltaic element portion (3), an intermediate layer (7) composed of metal oxide and having conductivity of a single film not lower than 2 × 10⁻¹² S/cm and not higher than 1 × 10⁻⁸ S/cm;
exposing said intermediate layer (7) to plasma containing hydrogen; and
stacking a second photovoltaic element portion (5) including at least one photovoltaic element on said intermediate layer (7) exposed to the plasma containing hydrogen.

11. The method of manufacturing a stack-type photovoltaic element (100) according to claim 10, wherein,
said step of stacking an intermediate layer (7) is the step of stacking an intermediate layer having conductivity of a single film not lower than 1 × 10⁻¹⁰ S/cm and not higher than 1 × 10⁻⁸ S/cm.

12. A method of manufacturing a stack-type photovoltaic element (100), comprising the steps of:
stacking a first photovoltaic element portion (3) including at least one photovoltaic element on a substrate (1);
stacking on said first photovoltaic element portion (3), an intermediate layer (7) composed of metal oxide and having sheet resistance of a single film higher than 100 MΩ/□;
exposing said intermediate layer (7) to plasma containing hydrogen; and
stacking a second photovoltaic element portion (5) including at least one photovoltaic element on said intermediate layer (7) exposed to the plasma containing hydrogen,
sheet resistance of the single film of said intermediate layer (7) exposed to the plasma containing hydrogen being not lower than 100 kΩ/□ and not higher than 26 MΩ/□.

13. The method of manufacturing a stack-type photovoltaic element (100) according to claim 12, wherein
said step of stacking an intermediate layer (7) is the step of stacking an intermediate layer having sheet resistance of the single film higher than 1 GΩ/□, and
said intermediate layer (7) subjected to said step of exposing said intermediate layer (7) to plasma containing hydrogen having sheet resistance of the single film not lower than 300 kΩ/□ and not higher than 20 MΩ/□.

14. A method of manufacturing a stack-type photovoltaic element (100), comprising the steps of:
stacking a first photovoltaic element portion (3) including at least one photovoltaic element on a substrate (1);
stacking an intermediate layer (7) composed of metal oxide on said first photovoltaic element portion (3);
exposing said intermediate layer (7) to plasma containing hydrogen; and
stacking a second photovoltaic element portion (5) including at least one photovoltaic element on said intermediate layer (7) exposed to the plasma,
said step of stacking an intermediate layer (7) being performed with sputtering using a target mainly composed of substantially undoped metal oxide under such a condition that a ratio of a flow rate of oxygen to argon is not lower than 1 % and not higher than 10%.

15. The method of manufacturing a stack-type photovoltaic element (100) according to any of claims 10 to 14, wherein
said second photovoltaic element portion (5) includes a microcrystalline semiconductor layer (5a) formed on said intermediate layer (7), and
said step of exposing said intermediate layer (7) to plasma containing hydrogen also serves as the step of forming said semiconductor layer (5a).

16. The method of manufacturing a stack-type photovoltaic element (100) according to any of claims 10 to 15, wherein
said metal oxide forming said intermediate layer (7) is zinc oxide.

17. The method of manufacturing a stack-type photovoltaic element (100) according to any of claims 10 to 16, wherein
said intermediate layer (7) has a thickness not smaller than 20 nm and not greater than 200 nm.

18. The method of manufacturing a stack-type photovoltaic element (100) according to any of claims 10 to 17, wherein
a semiconductor layer (3c) formed on an uppermost surface of said first photovoltaic element portion (3) on which said intermediate layer (7) is to be stacked is formed from a microcrystalline layer.

19. The method of manufacturing a stack-type photovoltaic element (100) according to claim 18, wherein
said microcrystalline layer is a microcrystalline silicon layer having crystallinity not lower than 1.5 and not higher than 10.

20. The method of manufacturing a stack-type photovoltaic element (100) according to claim 18, wherein
said microcrystalline layer is a microcrystalline silicon layer of which hydrogen content is not lower than 3 atomic % and not higher than 20 atomic %.

21. The method of manufacturing a stack-type photovoltaic element (100) according to claim 18, wherein
said microcrystalline layer is a microcrystalline silicon layer having conductivity not lower than 5 × 10⁻¹ S/cm.

22. The method of manufacturing a stack-type photovoltaic element (100) according to any of claims 18 to 21, wherein
said microcrystalline layer is a microcrystalline silicon layer having a thickness not smaller than 1 nm and not greater than 20 nm.

23. The method of manufacturing a stack-type photovoltaic element (100) according to any of claims 10 to 22, wherein
said first photovoltaic element portion (3) and said second photovoltaic element portion (5) are constituted of a photovoltaic element composed of a silicon-based semiconductor.

24. The method of manufacturing a stack-type photovoltaic element (100) according to any of claims 10 to 23, wherein
said intermediate layer (7) is composed of substantially undoped metal oxide.

25. The method of manufacturing a stack-type photovoltaic element (100) according to any of claims 10 to 24,
wherein a stack-type photovoltaic element having an integrated structure is manufactured.

26. The method of manufacturing a stack-type photovoltaic element according to any of claims 10 to 25, wherein
a photovoltaic element (31) located on a light incident side of said stack-type photovoltaic element among a plurality of photovoltaic elements included in said first photovoltaic element portion (3) or said second photovoltaic element portion (5) includes a pin structure, and an i-type layer (3b) constituting the pin structure is composed of any of amorphous silicon, amorphous silicon carbide, and amorphous silicon monoxide.

27. The method of manufacturing a stack-type photovoltaic element according to any of claims 10 to 26, wherein
a photovoltaic element located opposite to a light incident side of said stack-type photovoltaic element among a plurality of photovoltaic elements included in said first photovoltaic element portion (3) or said second photovoltaic element portion (5) includes a pin structure, and an i-type layer constituting the pin structure is composed of silicon containing a crystalline substance.
